(19) Europäisches Patentamt
European Patent Office
Office européen des brevets

(11) **EP 4 628 911 A1**

(12) **EUROPEAN PATENT APPLICATION**

(43) Date of publication:
**08.10.2025 Bulletin 2025/41**

(21) Application number: **24167973.7**

(22) Date of filing: **01.04.2024**

(51) International Patent Classification (IPC):
***G01R 31/392*** (2019.01)

(52) Cooperative Patent Classification (CPC):
**G01R 31/392;** G01R 31/367

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Hitachi Energy Ltd**
**8050 Zürich (CH)**

(72) Inventors:
• **Wang, Yang**
**Beijing, 100024 (CN)**
• **Chen, Ni Ya**
**Beijing, 100016 (CN)**

• **Liu, Lu**
**Beijing, 100029 (CN)**
• **Meng, DeLun**
**Beijing, 100018 (CN)**
• **Yang, XiaoBo**
**Beijing, 100015 (CN)**
• **Jiang, Wen**
**Beijing, 100015 (CN)**
• **Lei, Yu**
**Beijing, 100083 (CN)**

(74) Representative: **Meier, Florian**
**meier ip**
**Buschingstraße 65 (6. OG)**
**81677 München (DE)**

(54) **METHOD AND DATA PROCESSING SYSTEM FOR ONLINE STATE OF HEALTH DIAGNOSIS FOR A BATTERY ENERGY STORAGE SYSTEM, AND METHOD OF PROVIDING A DATA-DRIVEN PROCESSING MODEL THEREFOR**

(57) To perform an online state of health (SOH) diagnosis for a battery energy storage system (BESS) (40), a data processing system (20) determines incremental capacity analysis (ICA) data for a voltage range selected from a set of predefined voltage ranges. The data processing system (20) is operative to perform a feature extraction (33) to extract features from the ICA data for the voltage range, and to apply a data-driven processing model (34) that receives an input based on the features.

FIG. 1

**Description**

TECHNICAL FIELD

Embodiments relate to methods and data processing systems useful in association with a battery energy storage system. Embodiments relate in particular to methods and data processing systems operative to perform an online state of health diagnosis for a battery energy storage system.

BACKGROUND

The transition from conventional energy sources to non-conventional energy sources, such as renewable energy-based sources, is an important trend in many regions of the world. The transition is desired to reduce greenhouse gas transmissions and slow or, preferably, halt climate change. A consideration that comes with the transition renewable energy-based sources relates to energy storage. Energy storage is of particular importance for power grids, such as microgrids, other distributed energy resources (DERs), regional or national grids, and the importance of energy storage increases with ever increasing renewables penetration.

Battery energy storage systems (BESSs) are attractive to provide energy storage for power grids. However, the performance of a BESS degrades over time. The state of health (SOH) of a BESS can be quantified, e.g., as ratio of the actual capacity at a point in time during the BESS lifetime and the capacity upon installation of the BESS (i.e., when the BESS is in a non-degraded state). The SOH of BESS is useful data not only for determining when maintenance or replacement is to be performed, but also for performing control operations in association with a power grid, e.g., by curtailment of generators and/or controllable loads.

Thus, techniques of determining the SOH of a BESS are important in association with power grid operation. Techniques that allow the SOH of a BESS to be determined without requiring disassembly of the BESS are particularly attractive, as such techniques reduce or even completely eliminate interruptions in BESS field operation for determining the SOH of the BESS. Online SOH diagnosis allows the SOH to be determined during field operation of a BESS, sometimes even without having to transfer the BESS to a dedicated diagnosis operation state.

CN 116 299 003 A, CN 116 125 289 A, and CN 113 721 159 A disclose techniques useful in association with battery health estimation. However, there is still a need in the art for improved techniques of performing an online SOH diagnosis for a BESS.

SUMMARY

It is an objective of the invention to provide a method and a data processing system that provide enhanced techniques of performing an online SOH diagnosis for a BESS. It is an objective of the invention to provide a method and a data processing system that allow the SOH diagnosis to be performed without requiring the BESS to be disassembled from its installation site and/or which can determine the SOH without requiring a full charging cycle and/or a full discharging cycle to be performed. It is an optional objective of the invention to provide a method and a data processing system that allow the online SOH diagnosis to be performed using measurements collected during a part of a charging or discharging cycle, while offering the versatility of performing the online SOH diagnosis based on any one of several distinct parts of a load profile.

According to embodiments, a method, a data processing system, a method of providing a data-driven processing model, and a machine-readable instruction code recited in the independent claims are provided. The dependent claims define preferred or advantageous embodiments.

According to an aspect of the invention, there is provided a method of performing an online SOH diagnosis for a BESS is provided. The method comprises obtaining, by a data processing system, current measurements and voltage measurements as functions of time over a time interval, the current measurements and the voltage measurements being captured during charging or discharging of the BESS in constant current mode throughout the time interval, the current measurements and the voltage measurements being obtained for a voltage range selected from a set of predefined voltage ranges. The method further comprises determining, by the data processing system, incremental capacity analysis (ICA) data for the voltage range based on the current measurements and the voltage measurements, wherein determining the ICA data comprises determining, for each of a plurality of voltage values in the voltage range, an incremental change in charge stored by the BESS that is associated with an incremental change in voltage. The method further comprises performing, by the data processing system, a feature extraction to extract features from the ICA data for the voltage range. The method further comprises applying, by the data processing system, a data-driven processing model, wherein the data-driven processing model receives an input that is based on the features, and wherein the data-driven processing model outputs an SOH indicator.

Various effects and advantages are attained by the method. The method is operative to perform the SOH diagnosis without requiring the BESS to be disassembled from its installation site. The method is operative to determine the SOH indicator, which is indicative of the SOH, without requiring a full charging cycle and/or a full discharging cycle to be performed. More specifically, the method allows the SOH diagnosis to be performed even when ICA data is available for the voltage range, which may be smaller than the range of voltages exhibited during a full charging or discharging cycle. The method provides a more versatile SOH diagnosis that does not require full charging / discharging cycle to be performed. The method facilitates integration of SOH diagnosis in field operation. The method is operative to determine the SOH indicator irrespective of whether an active battery management (BMS) control or a passive BMS control is performed to perform the charging or discharging in constant current mode. By processing measurements obtained during charging or discharging in the constant current mode, the ICA data can be determined in a particularly efficient manner.

The online SOH diagnosis may be performed with the BESS remaining in situ at an installation site of the BESS and without disassembly of the BESS.

Thereby, the SOH diagnosis is integrated with field operation of the BESS, avoiding the downtime in BESS operation that would be associated with a disassembly of the BESS for performing the SOH diagnosis.

The ICA data may comprise sequence data comprising a sequence of 2-tuples, each 2-tuple comprising a voltage value (V) and a voltage-derivative of charge (dQ/dV) stored in the BESS at the respective voltage value, with the voltage values being included in the selected voltage range.

Thereby, feature extraction may be readily performed using feature extraction techniques capable to operate on sequence data.

The voltage measurements may respectively be terminal voltage measurements of the BESS.

Thereby, the voltage measurements can be readily obtained and may be used to determine the SOH indicator.

The feature extraction may comprise a feature extraction that operates on a sequence of 2-tuples, each 2-tuple comprising a voltage value (V) and a voltage-derivative of charge (dQ/dV) stored in the BESS at the respective voltage value, with the voltage values of all 2-tuples of the sequence being included in the selected voltage range.

Thereby, feature extraction may be readily performed using feature extraction techniques capable to operate on sequence data.

The features may be dependent on one, several, or all of: a location of at least one maximum or minimum of an ICA curve represented by the ICA data; a value of the ICA curve at the local maximum or local minimum; a shape and/or width of a peak of the ICA curve.

Thereby, characteristics of the ICA data may be extracted that are particularly suitable for determining the SOH indicator using the data-driven processing model. In particular, it has been found that the location of a local extremum of the ICA curve (i.e., the voltage values at which dQ/dV has a local maximum or a local minimum), the ICA value at the local extremum, and the peak shape and/or width vary with SOH. Thus, it is suitable for the extracted features to be dependent on these parameters in order to allow the SOH to be quantitatively determined by applying the data-driven processing model to such features.

The feature extraction may comprise applying a feature extraction tool operative to extract features from sequence data that are non-time-series data.

Thereby, feature extraction may be readily performed using feature extraction techniques capable to operate on sequence data that specify, for each of a plurality of voltage values in the selected voltage range, an associated value of the voltage-derivative of charge (dQ/dV) stored in the BESS.

The method may further comprise applying a collinearity analysis to the features to generate the input of the data-driven processing model.

Thereby, redundancy can be identified in the features extracted from the ICA data. This allows the data processing system to apply the data-driven processing model on input generated from the features, in which input redundant information has been removed or eliminated. This provides reliable SOH diagnosis results in a robust manner. The risk of overfitting can be reduced, improving SOH diagnosis results so that they even more accurately represent the SOH that would be attained by performing a full charge / discharge cycle to determine the SOH.

The method may further comprise generating input for the data-driven processing model based on features determined to be non-redundant in the collinearity analysis and/or by removing one or several features determined to have redundant information from the features to generate the input for the data-driven processing model.

Thereby, redundancy can be reduced or eliminated in the features extracted from the ICA data. The data processing system applies the data-driven processing model to its input, in which input redundant information has been removed or eliminated. This provides reliable SOH diagnosis results in a robust manner. The risk of overfitting is reduced, improving SOH diagnosis results so that they even more accurately represent the SOH that would be attained by performing a full charge / discharge cycle to determine the SOH.

The data-driven processing model may comprise an artificial intelligence (AI) model, such as a machine learning (ML) model.

Thereby, AI-based techniques can be applied to address the need for an enhanced technique of performing an online SOH diagnosis of a BESS.

**EP 4 628 911 A1**

The data-driven processing model may comprise any one or any combination of: a linear model; a k-means model; a support vector machine model; a Bayes model; a decision tree model; a gradient boosting model; a deep neural network, without being limited thereto.

Thereby, particularly reliable results are attainable in the online SOH diagnosis for the BESS.

The data-driven processing model may comprise model parameters set based on aging test measurements obtained in time periods in which a battery is charged and/or discharged in the constant current mode during offline battery aging tests.

Thereby, the results of offline aging tests, in which a wide range of states of health can be brought about in a controlled test setting, and battery characteristics can be ascertained for various states of health for subsequent use in online SOH diagnosis. The offline aging tests may comprise determining a plurality of ICA curves that correspond to different battery conditions, with the model parameters being set based on the plurality of ICA curves.

The model parameters may be model parameters set based the aging test measurements performed on the battery having an aging test battery cell type identical to a cell type that of the BESS.

Thereby, the data-driven processing model may be cell-type specific, taking into account that different cell types (e.g., different chemical compositions of the cells) will typically result in different ICA characteristics.

The model parameter may comprise model parameters of one or several of: a linear model; a k-means model, a support vector machine model; a Bayes model; a decision tree model; a gradient boosting model; a deep neural network, without being limited thereto..

Thereby, particularly reliable results are attainable in the online SOH diagnosis for the BESS.

The method may further comprise generating, by the data processing system or by a computing system separate from the data processing system, the data-driven processing model. Generating the data-driven processing model may comprise obtaining aging test ICA data based on aging test current measurements and aging test voltage measurements captured as functions of time during offline battery aging tests. Generating the data-driven processing model may further comprise segmenting the aging test ICA data into several segments associated with the predefined voltage ranges of the set of predefined voltage ranges. Generating the data-driven processing model may further comprise extracting aging test features from the several segments of the aging test ICA data. Generating the data-driven processing model may further comprise setting the model parameters of the data-driven processing model based on the aging test features and based on labels indicative of the SOH of the battery or the SOHs of the several batteries for which the aging test ICA data are obtained.

Thereby, offline aging tests (i.e., tests that are performed for a battery not connected to a power grid, optionally in a dedicated test setting) may be used to generate the data-driven processing model and, more specifically, set the parameters of the data-driven processing model. By using such the data-driven processing model generated in such a manner, the features extracted from the ICA data for online SOH diagnosis can be processed using objective criteria, which are embedded in the data-driven processing model.

Setting the model parameters may comprise setting the model parameters using supervised training and based at least on the aging test ICA data obtained from the measurements captured while charging or discharging is performed in the constant current mode.

Thereby, the data-driven processing model is specifically set up for use in processing features extracted from ICA data that are based on voltage and current measurements obtained, as a function of time, during charging in the constant current mode or discharging in the constant current mode. This allows the ICA data to be determined in a particularly robust and efficient manner, increasing the robustness of the SOH diagnosis.

The method may further comprise actively controlling, by an active BMS, the charging or the discharging of the BESS in the constant current mode to obtain the current measurements and the voltage measurements for the voltage range selected from the set of predefined voltage ranges.

Thereby, the charging or discharging in the constant current mode may be controlled in such a manner that the ICA data can be obtained for the voltages across the voltage range (e.g., from a minimum value to a maximum value of the voltage range selected from the set of predefined voltage ranges).

An active BMS may comprise the data processing system. The method may further comprise actively controlling, by the active BMS, the charging or the discharging of the BESS in the constant current mode to obtain the current measurements and the voltage measurements for the voltage range selected from the set of predefined voltage ranges. This may comprise causing, by the data processing system, the active BMS to actively control the charging or the discharging of the BESS in the constant current mode.

Thereby, the charging or discharging in the constant current mode may be performed in a controlled manner such that ICA data can be obtained for the voltages across the voltage range (e.g., from a minimum value to a maximum value of the voltage range selected from the set of predefined voltage ranges).

The BESS may be controlled by a passive BMS. The online SOH diagnosis may be performed conditionally dependent on the BESS being charged or discharged in the constant current mode with voltages in the voltage range selected from the set of predefined voltage ranges.

Thereby, the online SOH diagnosis can be performed responsive to constant current mode charging or discharging in which the measured voltages extend across the voltage range (e.g., from a minimum value to a maximum value of the voltage range selected from the set of predefined voltage ranges). This allows the online SOH diagnosis to be performed in a manner that is integrated into the field operation of the BESS, in which the BESS is charged (using, e.g., charge generated by energy sources that comprise renewable energy sources) or discharged. The online SOH diagnosis can be performed based on measurements obtained during the regular field operation of the BESS.

The SOH indicator may indicate the SOH of the BESS in a quantitative manner.

Thereby, the SOH indicator may be used for control operations that require the SOH to be quantitatively known.

The SOH indicator may be dependent on (e.g., equal or proportional to) a ratio of the capacity of the BESS at a time at which the voltage measurements and the current measurements are obtained, and the capacity of the BESS in a non-degraded state (e.g., upon installation of the BESS) and/or relative to a nominal capacity of the BESS.

The voltage range selected from the set may have a minimum voltage (as a lower limit of the voltage range) and a maximum voltage (as an upper limit of the voltage range). The difference between the maximum voltage and the minimum voltage may be equal to or less than 0.5 V, equal to or less than 0.3 V, equal to or less than 0.2 V, or equal to or less than 0.1 V.

Thereby, the online SOH diagnosis can be performed based on measurements acquired while the voltage varies across a voltage range that is small compared to the overall voltage interval through which the voltage varies during a full charging / discharging cycle of the BESS.

Each voltage range in the set of predefined voltage ranges may have a size equal to or less than 0.5 V, equal to or less than 0.3 V, equal to or less than 0.2 V, or equal to or less than 0.1 V.

Thereby, the online SOH diagnosis can be performed based on measurements acquired while the voltage varies across a voltage range that is small compared to the overall voltage interval through which the voltage varies during a full charging / discharging cycle of the BESS.

The set of predefined voltage ranges may comprise voltage ranges which have different sizes. Alternatively or additionally the set of predefined voltage ranges may comprise voltage ranges which are unevenly distributed (e.g., with a spacing between adjacent voltage ranges being variable from one pair of adjacent voltage ranges to a subsequent pair of adjacent voltage ranges).

Thereby, the voltage ranges may be set so as to allow reliable determination of the SOH based on the ICA data determined for the respective voltage range.

The set of predefined voltage ranges may comprise overlapping voltage ranges.

Thereby, the likelihood is increased that the voltage measurements span at least one of the voltage ranges, allowing the online SOH diagnosis to be performed. When an active control is employed by the BMS to perform the charging in the constant current mode or the discharging in the constant current mode, the online SOH diagnosis can be performed with little effect on the BESS field operation.

The method may further comprise performing or triggering, by the data processing system or by a system (such as a BMS or power conversion system) comprising the data processing system, a control operation based on the SOH indicator.

Thereby, the SOH indicator may be utilized to perform a control operation that is dependent on the BESS SOH. Examples for such control operations comprise BESS maintenance, initiation of dedicated BESS tests, controlling generator unit commitment (GUC) (e.g., by curtailment of renewables) and/or controlling controllable loads (e.g., by curtailing loads that can be controlled), controlling a power conversion system (PCS) for the BESS, providing the SOH indicator via a management or monitoring system, without being limited thereto.

The control operation may comprise controlling a human machine interface based on the SOH indicator.

Thereby, the SOH indicator may be provided in a manner which allows a corrective and/or mitigating and/or other operation to be performed in an electric power system comprising the BESS.

Alternatively or additionally, the control operation may comprise controlling a data interface to trigger a control operation. The control operation may comprise a control operation affecting the BESS.

Thereby, the control operation can be performed automatically or semi-automatically (e.g., responsive to an operator confirmation of a suggested control operation) based on the determined SOH indicator. The control operation may comprise any one or any combination of: controlling a PCS for the BESS, controlling GUC (e.g., by curtailment of renewables) and/or controlling controllable loads (e.g., by curtailing loads that can be controlled) based on the SOH of the BESS.

The method may further comprise generating the data-driven processing model, using the method of providing the data-driven processing model according to an aspect or embodiment disclosed herein.

According to another aspect of the invention, there is provided a control method of controlling an electric power system, comprising performing, by a control system, at least one control action based on the SOH indicator provided by the data processing system. The control method may comprise performing, by the data processing system, the SOH indicator using the method of performing the online SOH diagnosis according to any aspect or embodiment.

Thereby, control operations may be implemented automatically based on the SOH indicator.

According to another aspect of the invention, there is provided method of providing a data-driven processing model for online SOH diagnosis for a BESS. The method comprises obtaining, by at least one processing circuit, aging test ICA data based on aging test current measurements and aging test voltage measurements captured as functions of time during offline battery aging tests. The method further comprises segmenting, by the at least one processing circuit, the aging test ICA data into several segments associated with predefined voltage ranges of a set of predefined voltage ranges. The method further comprises extracting, by the at least one processing circuit, aging test features from the several segments. The method further comprises setting, by the at least one processing circuit, model parameters of the data-driven processing model based on the aging test features and based on labels indicative of the SOH of the aging test battery or the SOHs of the several aging test batteries for which the aging test ICA data are obtained, wherein the model parameters are set to configure the data-driven processing model such that it is operative to receive an input that is based on features extracted from ICA data obtained for the BESS for which the online SOH diagnosis is performed and to output an SOH indicator for the BESS. The method further comprises providing, by the at least one processing circuit, the data-driven processing model for performing the online SOH diagnosis.

Thereby, the data-driven processing model is generated that is useful in the method of performing an online SOH diagnosis according to an aspect or embodiment of the invention. This allows a data-driven processing model to be used, during inference, which is generated using aging test data acquired during offline tests.

The method of providing the data-driven processing model may further comprise controlling, by the at least one processing circuit, an HMI to enable an operator to specify a number and/or size of the predefined voltage ranges that define the set of predefined voltage ranges.

Thereby, the set of predefined voltage ranges can be configurable, optionally depending on the type of battery and/or characteristics of the aging test ICA data.

The method of providing the data-driven processing model may further comprise automatically setting, by the at least one processing circuit, the set of predefined voltage ranges.

Thereby, the set of predefined voltage ranges can be determined automatically, optionally depending on the type of battery and/or characteristics of the aging test ICA data.

The data-driven processing model may comprise any one or any combination of: a linear model; a k-means model; a support vector machine model; a Bayes model; a decision tree model; a gradient boosting model; a deep neural network, without being limited thereto.

Thereby, the method is operative to provide a data-driven processing model that allows particularly reliable results to be attainable in the online SOH diagnosis for the BESS during inference.

Providing the data-driven processing model may comprise transferring the parameter values of the data-driven processing model to the data processing system for use in performance of the online SOH diagnosis. This may be done in various ways, such as by wired or wireless transfer, by storing in a memory or storage system that is installed in the data processing system, or otherwise.

Thereby, the determined parameter values are made available for use in inference.

The method of providing the data-driven processing model may further comprise applying a collinearity analysis to the aging test features to generate training data for training the data-driven processing model.

Thereby, redundancy can be identified in the features extracted from the aging test ICA data. This provides data-driven processing model operative to perform a reliable SOH diagnosis in a robust manner. The risk of overfitting can be reduced, improving SOH diagnosis results so that they even more accurately represent the SOH that would be attained by performing a full charge / discharge cycle to determine the SOH.

The method of providing the data-driven processing model may further comprise generating training data for the data-driven processing model based on features determined to be non-redundant in the collinearity analysis and/or by removing one or several features determined to have redundant information from the features to generate the input for the data-driven processing model.

Thereby, redundancy can be reduced or eliminated in the features extracted from the aging test ICA data. The risk of overfitting is reduced, improving SOH diagnosis results so that they even more accurately represent the SOH that would be attained by performing a full charge / discharge cycle to determine the SOH.

The method of providing the data-driven processing model may be operative such that each voltage range in the set of predefined voltage ranges may have a size equal to or less than 0.5 V, equal to or less than 0.3 V, equal to or less than 0.2 V, or equal to or less than 0.1 V.

Thereby, the data-driven processing model can be generated such that online SOH diagnosis can be performed based on measurements acquired while the voltage varies across a voltage range that is small compared to the overall voltage interval through which the voltage varies during a full charging / discharging cycle of the BESS.

The method of providing the data-driven processing model may be operative such that the set of predefined voltage ranges may comprise voltage ranges which have different sizes. Alternatively or additionally The method of providing the data-driven processing model may be operative such that the set of predefined voltage ranges may comprise voltage ranges which are unevenly distributed (e.g., with a spacing between adjacent voltage ranges being variable from one pair of adjacent voltage ranges to a subsequent pair of adjacent voltage ranges).

Thereby, the data-driven processing model can be generated such that the predefined voltage ranges may be set so as to allow reliable determination of the SOH based on the ICA data determined for the respective voltage range.

The set of predefined voltage ranges may comprise overlapping voltage ranges.

Thereby, the data-driven processing model can be generated such that, during inference, the likelihood is increased that the voltage measurements span at least one of the voltage ranges, allowing the online SOH diagnosis to be performed. When an active control is employed by the BMS to perform the charging in the constant current mode or the discharging in the constant current mode, data-driven processing model can be generated such that, during inference, the online SOH diagnosis can be performed with little effect on the BESS field operation.

The aging test current measurements and the aging test voltage measurements captured as functions of time may comprise aging test current measurements and aging test voltage measurements captured during a full charging / discharging cycle or during several full charging / discharging cycles during the offline battery aging tests.

Thereby, the data-driven processing model can be provided such that, during inference, it can operate on features extracted from ICA data obtained from a variety of predefined voltage ranges.

The method of providing the data-driven processing model may further comprise aging the aging test battery (e.g., by exposing the aging test battery to heat in a controlled manner) to perform several full charging / discharging cycles during the offline battery aging tests.

Thereby, the data-driven processing model may be obtained in an efficient manner.

According to another aspect of the invention, there is provided machine-readable instruction code comprising machine-readable instructions which, when executed by at least one processing circuit, cause the at least one processing circuit to perform the method according to an aspect or embodiment of the invention.

The effects attained by the machine-readable instruction code correspond to the effects disclosed in association with the methods and systems according to various embodiments.

According to another aspect of the invention, there is provided non-transitory storage medium having stored thereon machine-readable instruction code comprising machine-readable instructions which, when executed by at least one processing circuit, cause the at least one processing circuit to perform the method according to an aspect or embodiment of the invention.

The effects attained by the non-transitory storage medium correspond to the effects disclosed in association with the methods and systems according to various embodiments.

According to another aspect of the invention, there is provided a data processing system for performing an online SOH diagnosis for a BESS. The data processing system comprises an interface operative to obtain current measurements and voltage measurements as functions of time over a time interval, the current measurements and the voltage measurements being captured during charging or discharging of the BESS in constant current mode, the current measurements and the voltage measurements being obtained for a voltage range selected from a set of predefined voltage ranges. The data processing system further comprises at least one processing circuit operative to: determine incremental capacity analysis, ICA, data for the voltage range based on the current measurements and the voltage measurements, the at least one processing circuit being operative to determine, for each of a plurality of voltage values in the voltage range, an incremental change in charge stored by the BESS that is associated with an incremental change in voltage; perform a feature extraction to extract features from the ICA data for the voltage range; and apply a data-driven processing model, wherein the data-driven processing model is operative to receive an input that is based on the features, and wherein the data-driven processing model is operative to output an SOH indicator.

Various effects and advantages are attained by the data processing system. The data processing system is operative to perform the SOH diagnosis without requiring the BESS to be disassembled from its installation site. The data processing system is operative to determine the SOH indicator, which is indicative of the SOH, without requiring a full charging cycle and/or a full discharging cycle to be performed. More specifically, the data processing system is operative such that it allows the SOH diagnosis to be performed even when ICA data is available for the voltage range, which may be smaller than the voltage interval exhibited during a full charging or discharging cycle. The data processing system provides a more versatile SOH diagnosis that does not require full charging / discharging cycle to be performed. The method facilitates integration of SOH diagnosis in field operation. The data processing system is operative to determine the SOH indicator irrespective of whether an active BMS control or a passive BMS control is performed to perform the charging or discharging in constant current mode. By processing measurements obtained during charging or discharging in the constant current mode, the data processing system can determine the in a particularly efficient manner.

Optional features of the data processing system according to various embodiments and the effects attained thereby correspond to the optional features and effects discussed in association with the methods according to embodiments.

The data processing system may be operative to perform the method of performing an online SOH diagnosis according to any aspect or embodiment disclosed herein.

The data processing system may be comprised by a BMS and/or a power conversion system (PCS). Thus, according to another aspect there is provided a BMS or PCS, comprising the data processing system according to an aspect or embodiment.

According to another aspect, there is disclosed a system, comprising a BESS, measurement instrumentation, and the data processing system according to an aspect or embodiment operative to communicatively interface with the measurements instrumentation to obtain the current measurements and the voltage measurements to perform the online SOH diagnosis.

Thereby, the effects discussed in association with the data processing method and data processing system are attained.

The system may comprise a BMS or PCS operative to control charging and/or discharging of the BESS. The BMS or PCS may be operative to control the charging and/or discharging responsive to a trigger from the data processing system (which may be integrated within the BMS or PCS) and/or responsive to the SOH indicator. The BMS or the PCS may comprise the data processing system.

Thereby, charging or discharging can be performed to determine the SOH indicator (in particular for an active BMS) and/or the SOH indicator may be used to control BESS operation.

The system may be an electric power system, such as an electric power grid (e.g., a microgrid) or a sub-system thereof, such as a power system substation, without being limited thereto. The system may comprise a microgrid comprising renewable energy sources.

Embodiments of the invention provide enhanced techniques of performing an online SOH diagnosis for a BESS. The method and data processing system according to embodiments allows the SOH diagnosis to be performed without requiring the BESS to be disassembled from its installation site and/or can determine the SOH without requiring a full charging cycle and/or a full discharging cycle to be performed. The method and data processing system according to embodiments allows the online SOH diagnosis to be performed using measurements collected during a part of a charging or discharging cycle, while offering the versatility of performing the online SOH diagnosis based on any one of several distinct parts of a load profile.

BRIEF DESCRIPTION OF THE DRAWINGS

Embodiments of the invention will be described with reference to the drawings in which similar or identical reference signs designate elements with similar or identical configuration and/or function.

Figure 1 is a schematic representation of a system comprising a and a data processing system operative to perform an online state of health diagnosis.

Figure 2 is a flow chart of a method of performing an online state of health diagnosis.

Figure 3 is a schematic representation of incremental capacity analysis data.

Figure 4 is a schematic representation of a load profile.

Figure 5 is a schematic representation of incremental capacity analysis data.

Figure 6 is a flow chart of a method of performing an online state of health diagnosis.

Figure 7 is a flow chart of a method of performing an online state of health diagnosis.

Figure 8 is a schematic representation of a system comprising the data processing system.

Figure 9 is a flow chart of a procedure useful in the method of performing an online state of health diagnosis.

Figure 10 is a schematic representation illustrating operation of the method of performing an online state of health diagnosis.

Figure 11 shows results obtained using the method of performing an online state of health diagnosis.

Figure 12 shows results obtained using the method of performing an online state of health diagnosis.

Figure 13 is a flow chart of a method of providing a data-driven processing model for use in performing an online state of health diagnosis of a battery energy storage system.

Figure 14 is a flow chart of a method of providing a data-driven processing model for use in performing an online state of health diagnosis of a battery energy storage system.

Figure 15 is a schematic representation of a system comprising the data processing system.

Figure 16 is a flow chart of a method that comprises the method of performing the online state of health diagnosis of a battery energy storage system.

Figure 17 is a flow chart of a method of performing an online state of health diagnosis.

Figure 18 is a flow chart of a method of performing an online state of health diagnosis.

DETAILED DESCRIPTION OF EMBODIMENTS

Embodiments of the invention will be described with reference to the drawings. In the drawings, similar or identical reference signs designate elements with similar or identical configuration and/or function.

Embodiments relate to methods, data processing systems, and systems useful in association with performing an online SOH diagnosis for a BESS. Battery cells of a BESS degrade, resulting in a reduction in capacity due to the degradation of active material on cathode and/or anode. Solid Electrolyte Interphase (SEI) formation is a further root cause for a reduction of BESS capacity over time. Battery cells are often considered as having a malfunction when the remaining capacity is below 80% of their Beginning of Life (BOL) value. During field operation, it may be challenging to find an opportunity to conduct a 0-100% Depth of Discharge (DOD) charging / discharging cycle to determine the full capacity of battery cells. The challenge of performing an online SOH diagnosis is exacerbated by the fact that the BESS system can operate under a dynamic and unpredictable load profile. In such an operation scenario, the load profile could be split up into several portions, each having constant stress factors, and the cumulative capacity loss could be calculated in a piece-wise manner. However, such an approach may be complex and may require measurements of factors that affect aging (such as temperature) which may not always be available with sufficient accuracy. Techniques that use a matrix with orthogonal stress factors generally have shortcomings for online BESS where stress factors (such as temperature, charging rate, state of charge (SOC), DOD, rest time, etc.) may be unknown or may be variable as a function of time.

The methods, data processing systems, and systems according to embodiments utilize incremental capacity analysis (ICA) in combination with feature extraction to extract features from a voltage range selected from a set of predefined voltage ranges, to perform the SOH diagnosis. An SOH indicator, such as the ratio of the capacity of the BESS divided by the BOL capacity, may be determined by applying a data-driven processing model (such as a gradient boosting model or other AI model, e.g., a linear model, a k-means model; a support vector machine model, a Bayes model, a decision tree model, or a deep neural network) to an input that is determined based on the features extracted from the ICA data over the voltage range. Thereby, the SOH indicator is determined in an objective manner, without requiring a 0-100% DOD charging / discharging cycle to be conducted and without requiring the BESS to be removed from its installation site and/or to be disassembled.

As used herein, the term "online diagnosis" refers to a diagnosis that is performed while a finite current (e.g., to and/or from a bus or line of the power grid) causes the open circuit voltage (OCV) of the BESS to be different from a terminal voltage.

As used herein, the term "voltage measurements" and "voltage" refers to a terminal voltage of the BESS, unless specifically stated otherwise. The terminal voltage, which can be readily measured for use in the techniques herein, is generally different from the OCV of the BESS when there is a finite current flow. As will be further described herein, methods and data processing systems as disclosed herein are operative to determine ICA data based on current measurements and based on voltage measurements (i.e., measurements of the terminal voltage) collected during constant current (CC) mode charging or CC mode discharging.

As used herein, a "set of predefined voltage ranges" refers to several voltage ranges, each having a predefined (fixed) lower and upper range limit. A "size" of the voltage range refers to a difference of the upper range limit and the lower range limit. A voltage range is "predefined" when its lower and upper range limits are fixed prior to performing the online SOH diagnosis. Information on the predefined voltage ranges may be stored persistently (i.e., in a non-volatile manner) in a storage or memory system of the data processing system that performs the online SOH diagnosis. The "set of predefined voltage ranges" may be dependent on a cell type of the BESS. For use in association with BESS having different cell types, the data processing system may store different sets of predefined voltage ranges. The predefined voltage ranges may be predefined in the sense that they may be dependent on ICA curves captured during offline battery aging tests (i.e., while the battery is in a controlled environment and not directly or indirectly coupled to the power grid), and in particular on the locations of local extrema of the ICA curves captured during the offline battery aging tests for various SOHs.

As used herein, an "SOH indicator" comprises a quantity that is indicative of the SOH. The SOH indicator may comprise or may be a numerical value that quantifies the SOH. The SOH indicator may comprise or may be dependent on (e.g., may equate or may be proportional to) the ratio of the BESS capacity at the time of the online SOH diagnosis (more specifically: at the time of collecting the voltage measurements in CC mode charging or CC mode discharging of the BESS and collecting the current measurements during the CC mode charging or the CC mode discharging of the BESS) and the BESS capacity at the BOL of the BESS.

As used herein, a BMS is considered an "active BMS" if it is operative to cause CC mode charging or CC mode discharging to be performed within a desired region of a load profile. A BMS is considered to be a "passive BMS" if it is not operative to cause CC mode charging or CC mode discharging to be performed within a desired region of a load profile responsive to a command or other signal from the data processing system that performs the online SOH diagnosis.

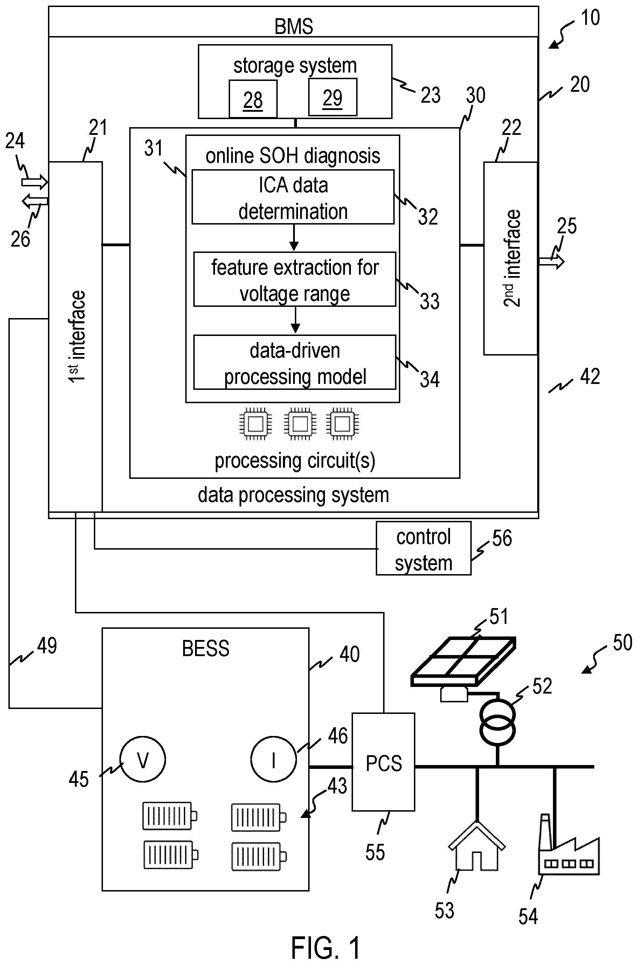

Figure 1 shows a schematic representation of a system 10. The system 10 comprises an electric power system 50 and a data processing system 20 operative to perform an online SOH diagnosis of the SOH of a BESS 40. The electric power system 50 comprises the BESS 40. The electric power system 50 may comprise a power grid, such as a microgrid and/or a distributed energy resource (DER), comprising one or several renewable power sources 51 coupled to a bus via a transformer, converter, or a converter/inverter 52. The electric power grid may comprise one or several loads 53, 54. The one or several loads 53, 54 may comprise at least one load that can be curtailed or otherwise controlled, depending on the energy available from the energy source(s) and the BESS 40. The electric power system 50 may comprise a control system 56 operative to control one or several renewable energy sources, such as by controlling generator unit commitment (GUC) (e.g., by controlling setpoints for photovoltaic or wind energy sources). The control system 56 may be operative to control one or several controllable loads, e.g., by causing load curtailment to be performed.

The BESS 40 may be coupled to a bus or line of the electric power system 50 via the PCS 55. The BESS 40 is operative to receive electric power via the PCS 55, store the electric power in plurality of batteries 43 of the BESS 40, and to provide the stored electric power via the PCS 55. The BESS 40 may comprise or may be coupled to a BMS 42. The BMS 42 may be an active BMS or a passive BMS. The BMS 42 need not be integrated into the BESS 40, but may also be provided separately therefrom, e.g., as a separate component or integrated with the PCS 55.

The system 10 comprises measurement instrumentation operative to obtain voltage measurements (i.e., measurements of the terminal voltage of the BESS 40) and current measurements. The measurement instrumentation may comprise voltage measurement instrumentation 45 and current measurement instrumentation 46. The voltage measurement instrumentation 45 may be operative to measure the terminal voltage of the BESS 40. The current measurement instrumentation 46 may be operative to measure the charging current during BESS charging and the discharging current during BESS discharging. The voltage and current measurements may be obtained continually, i.e., on an ongoing basis. The voltage measurements and the current measurements may be captured at least while the BESS 40 is charged in CC mode or while the BESS 40 is discharged in CC mode. The data processing system 20 is operative to process the voltage measurements and the current measurements captured during CC mode charging or during CC discharging of the BESS 40. The data processing system 20 is operative to determine ICA data from the voltage measurements and from the current measurements, the ICA data being indicative of an increment in charge in the BESS 40 (dQ) that is caused by an increment in terminal voltage (dV), respectively as a function of terminal voltage V. The data processing system 20 is further operative to perform a feature extraction on the ICA data representing dQ/dV as a function of voltage, for voltages over a voltage range selected from a set of predefined voltage ranges.

The data processing system 20 comprises at least one first interface 21 operative to be communicatively coupled to the measurement instrumentation 45, 46. The data processing system 20 may be operative to be communicatively coupled to the control system 56 and/or the PCS 55. While the data processing system 20 is schematically shown separately from the PCS 55, the data processing system 20 may be integrated with the PCS 55. The data processing system 20 may be integrated with the BMS 42, as schematically shown in Figure 1. The data processing system 20 may be operative to communicatively interface with one, several, or all of the measurement instrumentation 45, 46, the control system 56, and/or the PCS 55 via associated communication links (such as communication link 49) which may be implemented as point-to-point communication links or as bus-type links. The communication links may comprise wired and/or wireless communication links. The data processing system 20 may be operative to receive measurements 24 captured during CC mode charging or during CC mode discharging. The data processing system 20 is operative to process the measurements to determine the SOH indicator. The data processing system 20 is operative to generate output based on the SOH indicator. The output may comprise one or several control commands or signals 26, which may be provided to the BMS 42, the measurement instrumentation 45, 46, and/or the PCS 55.

The data processing system 20 may optionally comprise at least one second interface 25, which may comprise or may be coupled to an HMI. The output may comprise output 25 that controls the HMI based on the SOH indicator, thereby enabling outputting of the SOH indicator or other technical data based thereon via the HMI.

The data processing system 20 comprises a storage system 23 and at least one processing circuit 30. The at least one processing circuit 30 is operative to be communicatively coupled with the at least one first interface 21 and, if present, with the at least one second interface 22. The at least one processing circuit 30 may be operative to access a storage system 23 of the data processing system 20 or coupled to the data processing system 20. The storage system 23 may have stored therein voltage range definitions 28 defining a set of predefined voltage ranges. The voltage range definitions 28 may comprise several distinct sets of predefined voltage ranges, each associated with a different battery cell type (such as lithium iron phosphate battery (LFP), nickel-manganese-cobalt (NMC), lithium-titanate-oxide (LTO), etc.). The storage system 23 may have stored therein parameter values 29 for a data-driven processing model 34. The parameter values 29 may comprise parameter values set based on offline battery aging tests. The parameter values 29 may comprise several distinct sets of parameter values, each associated with a different battery cell type (such as LFP, NMC, LTO, etc.).

The at least one processing circuit 30 is operative to process the current measurements and the voltage measurements, captured during CC mode discharging of the BESS 40 or during CC mode charging of the BESS 40. The at least one processing circuit 30 is operative to perform an ICA data determination 32. The ICA data determination may comprise determining dQ/dV (i.e., the incremental change in BESS charge, dQ, caused by an incremental change in terminal voltage, dV) as a function of the voltage V (which is the terminal voltage), for voltages that vary throughout a voltage range selected from the set of predefined voltage ranges.

The at least one processing circuit 30 is operative to perform a feature extraction 33 on the ICA data for the voltage range. The feature extraction may comprise extracting features that are dependent on a voltage at which an ICA curve representing dQ/dV exhibits a local maximum or local minimum, the value of the ICA curve at the local maximum or at the local minimum, the slope of the ICA curve, a peak width of the local maximum or the local minimum, respectively within the voltage range.

The at least one processing circuit 30 is operative to apply a data-driven processing model 34 to input that is based on the features extracted in the feature extraction 33. The data-driven processing model 34 may comprise an AI model, wherein parameter value of the AI model are accessible to the at least one processing circuit 30 from the storage system 30. The data-driven processing model 34 may comprise a gradient boosting model, such as XGBoost, without being limited thereto. The data-driven processing model 34 may comprise, e.g., any one or any combination of: a linear model; a k-means model; a support vector machine model; a Bayes model; a decision tree model; a gradient boosting model; a deep neural network, without being limited thereto. The data-driven processing model 34 receives the input that is dependent on the features extracted in the feature extraction 33. The input does not need to include all of the extracted features, but may include, e.g., a subset of the features obtained by removing features that include redundant information, based on a collinearity analysis performed by the at least one processing circuit 30. The data-driven processing model 34 has an output providing the SOH indicator.

The at least one processing circuit 30 is operative to perform an online SOH diagnosis 31, based on the ICA data determination 32, the feature extraction 33 performed for a voltage range selected from a set of predefined voltage ranges, and the application of the data-driven processing model, to thereby determine the SOH indicator. To perform the mentioned operations, the at least one processing circuit 30 may comprise any one or any combination of integrated circuits, integrated semiconductor circuits, processors, controllers, application specific integrated circuits (ASICs), field programmable gate arrays (FPGAs), circuit(s) including quantum bits (qubits) and/or quantum gates, without being limited thereto.

The data processing system 20 may be operative to generate output 26 based on the SOH indicator, to cause at least one control action to be performed. The at least one control action may comprise any one or any combination of a control of the PCS 55, curtailment of a generator 51 (e.g., by changing the GUC, such as by changing the generator setpoint), curtailment of a load, automatic scheduling of BESS downtime for maintenance, or other control operations. Alternatively or additionally, the data processing system 20 may be operative to generate output 25 based on the SOH indicator for controlling an HMI based on the SOH indicator, e.g., for presenting an alert, warning, or other status information related to the SOH of the BESS 40.

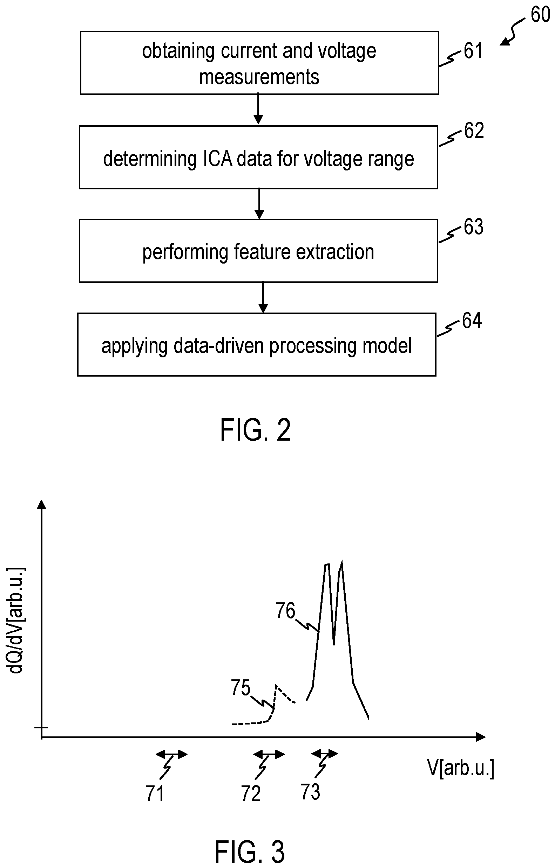

Figure 2 is a flow chart of a method 60 of performing an online SOH diagnosis for a BESS. The method 60 may be performed automatically by the data processing system 20.

At process block 61, current measurements are obtained during CC mode charging of the BESS or during CC mode discharging of the BESS. Several current measurements may be obtained to verify that the charging current has remained constant and/or to determine the start and end of the CC mode charging or the CC mode discharging. Voltage measurements are obtained during the CC mode charging of the BESS or during the CC mode discharging of the BESS. The voltage measurements may be obtained in an ongoing basis (i.e., continually) during the CC mode charging or during the CC mode discharging. The voltage measurements may be obtained in regular time intervals, or with varying temporal intervals. The voltage measurements comprise measurements of a terminal voltage of the BESS. Obtaining the current and voltage measurements may comprise communicatively interfacing, by the data processing system, with the measurement instrumentation 45, 46, either directly or via a communication system that may comprise an intelligent electronic device (IED), such as a merging unit (MU) and/or a gateway device. The current and voltage measurements are obtained during the CC mode charging or the CC mode discharging, while the voltage varies across a voltage range that is included in (and, thus, selected from) the set of predefined voltage ranges. The voltage range may have a size of, e.g., 0.5 V or less, 0.4 V or less, 0.3 V or less, 0.2 V or less, or 0.1 V or less. The size of the voltage range may be dependent on the type of battery cell of the BESS.

At process block 62, the measurements obtained at process block 61 are processed to determine ICA data. The ICA data may respectively represent the change in charge in the BESS (which is also designated with dQ) caused by an incremental change in terminal voltage (which is also designated with dV), divided by the incremental change in the terminal voltage during the CC mode charging or during the CC mode discharging. This quantity, representing the derivative of the charge in the BESS over terminal voltage, is a function of the terminal voltage. The quantity dQ/dV is determined at least for several voltages within the voltage range selected from the set of predefined voltage ranges, over which the voltage measurements obtained at process block 61 vary. Determining the ICA data may comprise an integration of the measured current over a time interval (such as an incremental time interval) in which the terminal voltage changes, to thereby determine dQ. Determining the ICA data may comprise determining the change in voltage dV over the time interval over which the current is integrated. Determining the ICA data may comprise calculating the ratio of dQ and dV. Determining the ICA data may comprise repeating the integration of current over time, the determination of an associated voltage change, and the computation of a ratio of these two quantities for several voltages (e.g., the start, end, or median voltage in the respective time interval). The determination may be performed such that the value of dV (i.e., the variation within the time interval over which the current is integrated to determine dQ and, thus, dQ/dV, corresponds to less than 4%, less than 3%, or 2% or less than 2% dynamic SOC (dSOC).

At process block 63, a feature extraction is performed on the ICA data. Performing the feature extraction may comprise generating sequence data comprising a sequence of 2-tuples, each comprising a voltage in the voltage range selected from the set of predefined voltage ranges, and the value of dQ/dV at that respective voltage. The feature extraction may operate on such sequence data different from time series data, to thereby extract features of the ICA curve limited to the voltage range selected from the set of predefined voltage ranges. The feature extraction may provide features that are dependent on a voltage at which an ICA curve representing dQ/dV exhibits a local maximum or local minimum, the slope of the curve dQ/dV (which corresponds to the second derivative of Q(V) over V), the value of the ICA curve at the local maximum or at the local minimum, the slope of the ICA curve, a peak width of the local maximum or the local minimum, respectively within the voltage range.

At process block 64, a data-driven processing model is applied to an input that is based on the features extracted at process block 63. The input may comprise at least some of the features and/or linear combinations thereof. The input may be generated from the features obtained at process block 63 by applying a collinearity analysis to identify redundant information and removing features that are determined to be redundant, based on the collinearity analysis. The data-driven processing model provides the SOH indicator as output. The data-driven processing model may comprise or may be an AI model, such as an ML model. The data-driven processing model may in particular comprise or be a gradient boosting model, such as XGBoost, without being limited thereto. The data-driven processing model may comprise any one or any combination of: a linear model; a k-means model; a support vector machine model; a Bayes model; a decision tree model; a gradient boosting model; a deep neural network, without being limited thereto.

The processing performed by the data processing system 20, such as the determination of the ICA data by the ICA data determination 32 and/or in process block 63, may take advantage of the fact that the cell OCV shows a relationship with cell SOC. The OCV-SOC relationship changes with battery cell degradation. For illustration for a Lithium iron phosphate (LFP) cell, in OCV-SOC curve, there may generally exist a plateau in the middle range of SOC, which makes it challenging to detect the relationship. Incremental capacity analysis (ICA), as performed by the data processing system 20 and the method, calculates the first order derivative dQ/dV as a function of terminal voltage V to highlight the hidden relationship between OCV and SOC.

According to the equivalent circuit model (ECM) model of the BESS, the OCV is different from terminal voltage if the current in circuit is not zero. Usually, the OCV measurement needs the battery to reach a fully relax status, i.e., the equivalent capacitors are fully discharged. However, during online operation there is a finite (i.e., non-zero) charging / discharging current in most case. Thus, there will be limited opportunity for the battery to reach such an equilibrium status, and thus it is conventionally challenging to measure the OCV value online.

The data processing system 20 and the method 60 use measurements obtained in CC mode charging or CC mode discharging to approximate the change in OCV by the change in terminal voltage. Thus, the data processing system 20 and the method 60 are operative to determine, based on the measurements captured during the CC mode charging or the CC mode discharging,

$$dQ/dOCV \approx dQ/dV \qquad (1)$$

By determining the right-hand side of Eq. (1) from the measurements, the data processing system 20 and the method 60 are operative to approximately determine dQ/dOCV, which exhibits characteristics that are dependent on the SOH of the battery, even when known only over the voltage range selected from the plurality of predefined voltage ranges.

In more detail, and without being bound by theory, the terminal voltage and the OCV differ by the product of the current and the total equivalent impedance of the ECM during charging or during discharging. By considering an incremental change in terminal voltage and OCV during CC mode charging or CC mode discharging, the incremental change of the product of the current and the total equivalent impedance of the ECM during charging or during discharging can be neglected, as the incremental change of total impedance is negligible within a voltage interval that is small enough, corresponding to, e.g., less than 4%, less than 3%, or 2% or less than 2% dynamic SOC (dSOC); and the current is independent of voltage during CC mode charging or CC mode discharging.

The data processing system 20 and the method 60 can, thus, determine the ICA data as

$$dQ/dOCV \approx dQ/dV = \frac{\int_{t_k}^{t_{k+1}} I(t)dt}{V(t_{k+1}) - V(t_k)} = \frac{I_{CC} \times (t_{k+1} - t_k)}{V(t_{k+1}) - V(t_k)}$$

$$(2)$$

where $I(t)$ is current as a function of time during CC mode charging or CC mode discharging (causing the integral in the numerator to become equal to the (constant) current $I_{CC}$ during CC mode charging and/or discharging, multiplied by $(t_{k+1} - t_k)$), $V(t_{k+1})$ is the terminal voltage at time $t_{k+1}$, $V(t_k)$ is the terminal voltage at time $t_k$, $k$ is an index for various points in time during the CC mode charging or the CC mode discharging, and $t_{k+1}$ and $t_k$ are selected such that at least one of $V(t_{k+1})$ and $V(t_k)$ is included in the voltage range selected from the set of predefined voltage ranges, and that the difference $V(t_{k+1}) - V(t_k)$ is small (e.g., less than 5% or less than 4 % or less than 3%) compared to the voltage interval over which the voltage varies during a full 0-100% DOD charging / discharging cycle. The right-hand side of Eq. (2) represents an example of ICA data, with the right-hand side being evaluated for several (e.g., at least ten, at least twenty, at least thirty, or at least forty) different incremental changes between different points in time $t_k$ to determine the dependency of dQ/dV as a function of voltage over the voltage range selected from the set of predefined voltage ranges.

Operation of the data processing system 20 and the method 60 of performing the online SOH diagnosis will be explained in more detail with reference to Figure 3, Figure 4, and Figure 5.

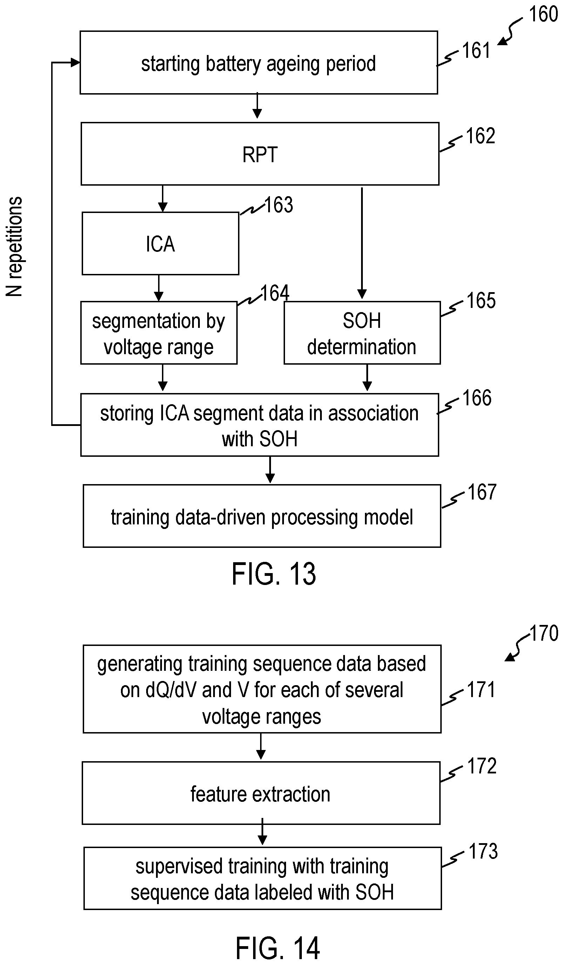

Figure 3 shows a schematic representation of ICA data 75, 76 determined based on current and voltage measurements during CC mode charging or CC mode discharging. The ICA data 75 is determined for at least a voltage range 72 selected from the set of predefined voltage ranges 71, 72, 73. Other ICA data 76 (which may be obtained from a different or the same BESS with a different SOH) is determined for at least another voltage range 73 selected from the set of predefined voltage ranges 71, 72, 73. The predefined voltage ranges 71, 72, 73 may be predefined in the sense that they are fixed and known prior to the online SOH diagnosis and/or that they are independent of the ICA data 75, 76. The predefined voltage ranges 71, 72, 73 may be predefined, both with regard to their number and their lower and upper range limits, based on ICA curves captured during offline battery aging tests, as will be described in more detail in association with Figure 13. The voltage range selected from the set of predefined voltage ranges may be the one(s) of the several voltage ranges which the voltage measurements obtained during the CC mode charging or the CC mode cover from a lower range limit to the upper range limit.

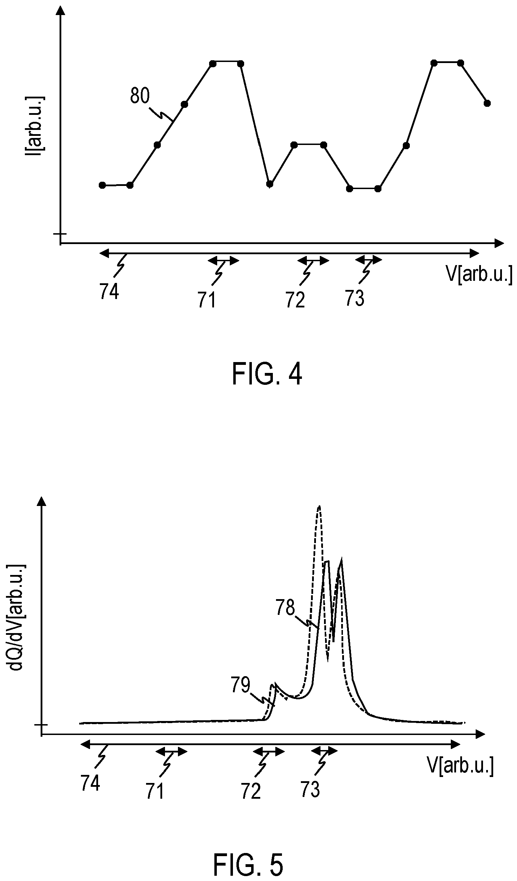

Figure 4 shows an illustrative load profile 80 that may be applied for charging or discharging the BESS. The load profile is selected such that, to determine the ICA data for a voltage range, the load profile corresponds to a CC mode charging or CC mode discharging in the respective voltage range 71, 72, 73 selected from the set of predefined voltage ranges. Each of the predefined voltage ranges 71, 72, 73 may have a size that is small compared to a voltage interval 74 that corresponds to a 0-100% charging / discharging cycle.

As also schematically illustrated in Figure 3 and Figure 4, the set of predefined voltage ranges 71, 72, 73 may comprise voltage ranges having different sizes. Alternatively or additionally, the set of predefined voltage ranges 71, 72, 73 may comprise voltage ranges that are unevenly distributed (e.g., in the sense that a difference between the upper range limit of a voltage range and the lower limit of the next higher voltage range varies from one pair of successive voltage ranges 71, 72 to another pair of successive voltage ranges 72, 73).

Figure 5 schematically illustrates ICA data 78, 79 obtained for a full, 0-100% DOD charging / discharging cycle. The ICA data 78 and the further ICA data 79 correspond to different SOH of the BESS. The data processing system 20 and the method 60 are operative to determine the SOH indicator without requiring the ICA data 78, 79 for a full 0-100% DOD charging / discharging cycle. The data processing system 20 and the method 60 are operative to determine the SOH indicator based on the ICA data, provided that the ICA data is available for at least one of the predefined voltage ranges included in the set of predefined voltage ranges. To attain this, the data processing system 20 and the method 60 utilize feature extraction (applied to the ICA data over the voltage range), optional removal of redundant information from the features, and application of the data-driven processing model to input that is dependent on (e.g., which includes or represents linear combinations of) features extracted by the feature extraction as applied to the ICA data over the voltage range.

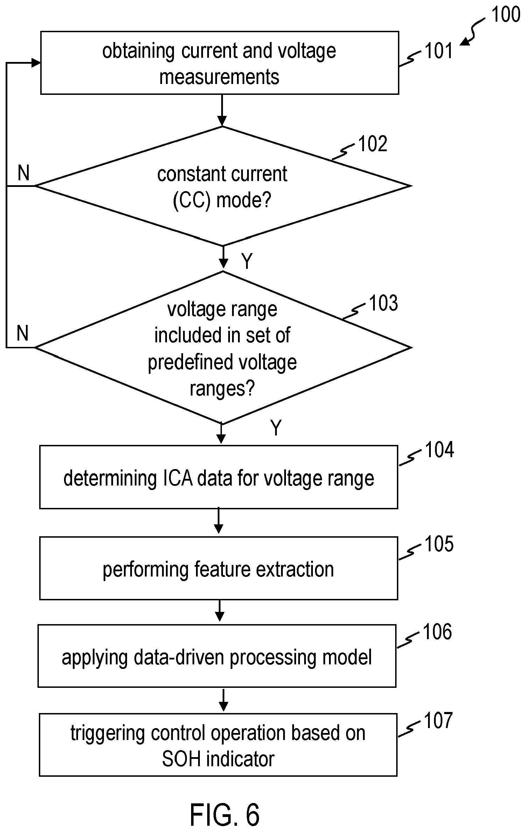

Figure 6 is a flow chart of a method 100 of performing an online SOH diagnosis for a BESS. The method 100 may be performed automatically by the data processing system 20.

At process block 101, current and voltage measurements are obtained.

At process block 102, it is determined whether CC mode charging or CC mode discharging is performed. The determination may be performed based on the current measurements. If it is determined that no CC mode charging or CC mode discharging is performed, the method 100 returns to process block 101.

At process block 103, it is determined whether the voltage measurements obtained during the CC mode charging or the CC mode discharging extend between the lower and upper range limits of a voltage range included in the set of predefined voltage ranges, such that the voltage measurements extend across the voltage range in its entirety (from the lower range limit to the upper range limit, or vice versa). If none of the predefined voltage ranges in the set (stored, e.g., in the storage or memory system 23) is completely covered by the voltage measurements, the method 100 returns to process block 102.

At process block 104, ICA data are determined for the voltage range, based on the obtained measurements.

At process block 105, a feature extraction is performed to extract features from the ICA data over the voltage range. The feature extraction may be operative to extract features from sequence data that are non-time series data, such as a sequence of 2-tuples including voltage and associated dQ/dV values.

At process block 106, a data-driven processing model is applied to input that depends on the extracted features. The input may comprise some (or even all) of the features extracted at process block 105, or linear combinations of some (or even all) of the features extracted at process block 105.

At process block 107, a control operation may be triggered based on the SOH indicator. The control operation may comprise an HMI control operation and/or a control operation that triggers the PCS, the BMS, and/or another control system of the electric power system 50 to perform an operation that depends on the SOH indicator (e.g., based on the ratio of the capacity at the time of capturing the measurements and the capacity at the BOL).

Process blocks 101, 104, 105, and 106 of the method 100 may be implemented as previously described in association with process blocks 61, 62, 63, and 63 of the method 60.

The method 100 is operative for use in association with a passive BMS. The method 100 does not require that a load profile for charging or discharging be actively set so as to perform CC mode charging or CC discharging across a voltage range that is included in the set of predefined voltage ranges. The method 100 is operative to monitor, in an ongoing basis (i.e., continually) during field operation of the BESS whether CC mode charging or CC mode discharging is performed with the voltage measurements covering a voltage range that is included in the set of predefined voltage ranges. Responsive to confirming this (at process blocks 102, 103), the SOH indicator is determined.

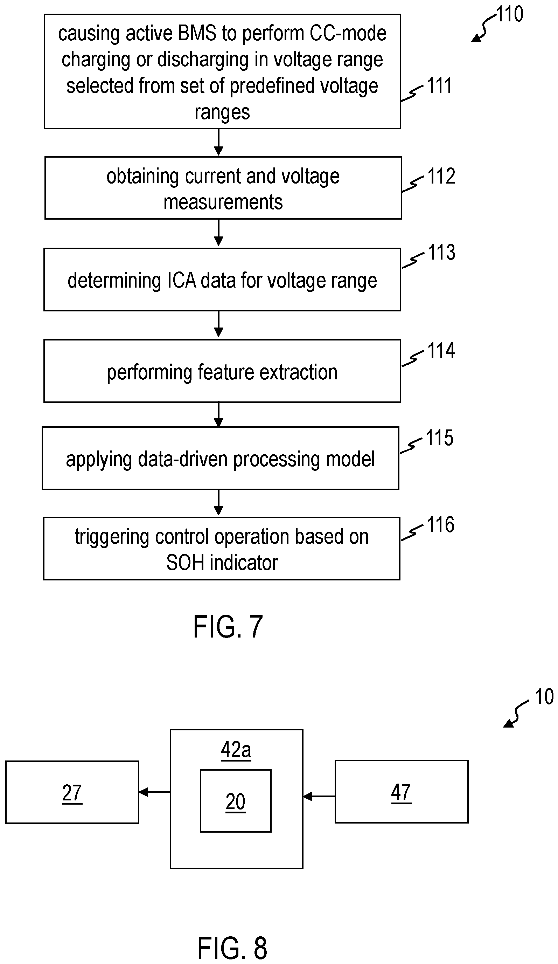

Figure 7 is a flow chart of a method 110 of performing an online SOH diagnosis for a BESS. The method 110 may be performed automatically by the data processing system 20. The data processing system 20 may be operative to communicatively interface with a BMS that is implemented as an active BMS. The active BMS may be operative to perform CC mode charging or CC mode discharging in accordance so as to capture current and voltage measurements for a voltage range selected in the set of predefined voltage ranges.

At process block 111, the data processing system 20 triggers the active BMS to perform CC mode charging or CC mode discharging. The BMS may cause CC mode charging or CC mode discharging to be performed so as to capture current and voltage measurements for a voltage range selected in the set of predefined voltage ranges.

At process block 112, the current and voltage measurements are obtained.

At process block 113, ICA data are determined for the voltage range, based on the obtained measurements.

At process block 114, a feature extraction is performed to extract features from the ICA data over the voltage range. The feature extraction may be operative to extract features from sequence data that are non-time series data, such as a sequence of 2-tuples including voltage and associated dQ/dV values.

At process block 115, a data-driven processing model is applied to input that depends on the extracted features. The input may comprise some (or even all) of the features extracted at process block 115, or linear combinations of some (or even all) of the features extracted at process block 115.

At process block 116, a control operation may be triggered based on the SOH indicator. The control operation may comprise an HMI control operation and/or a control operation that triggers the PCS, the BMS, and/or another control system of the electric power system 50 to perform an operation that depends on the SOH indicator (e.g., based on the ratio of the capacity at the time of capturing the measurements and the capacity at the BOL).

Process blocks 112, 113, 114, and 115 of the method 110 may be implemented as previously described in association with process blocks 61, 62, 63, and 63 of the method 60.

Figure 8 is a schematic representation of a system 10 comprising a BMS implemented as an active BMS 42a. The data processing system 20 may be integrated into the active BMS 42a. I.e., the active BMS 42a may comprise the data processing system 20. The active BMS 42a may cause CC mode charging or CC mode discharging to be performed. The active BMS 42a may cause CC mode charging or CC mode discharging to performed so as to capture current and voltage measurements for a voltage range selected in the set of predefined voltage ranges

The system 10 further comprises measurement instrumentation 47 and an HMI 27. The data processing system 20 is operative to obtain the current and voltage measurements from the measurement instrumentation 47. The data processing system 20 may be operative to control the HMI 27 based on the SOH indicator.

The method 110 of Figure 7 and the system 10 of Figure 8 allow the charging and/or discharging to be controlled in a manner useful for acquiring the current and voltage measurements required to determine the SOH indicator.

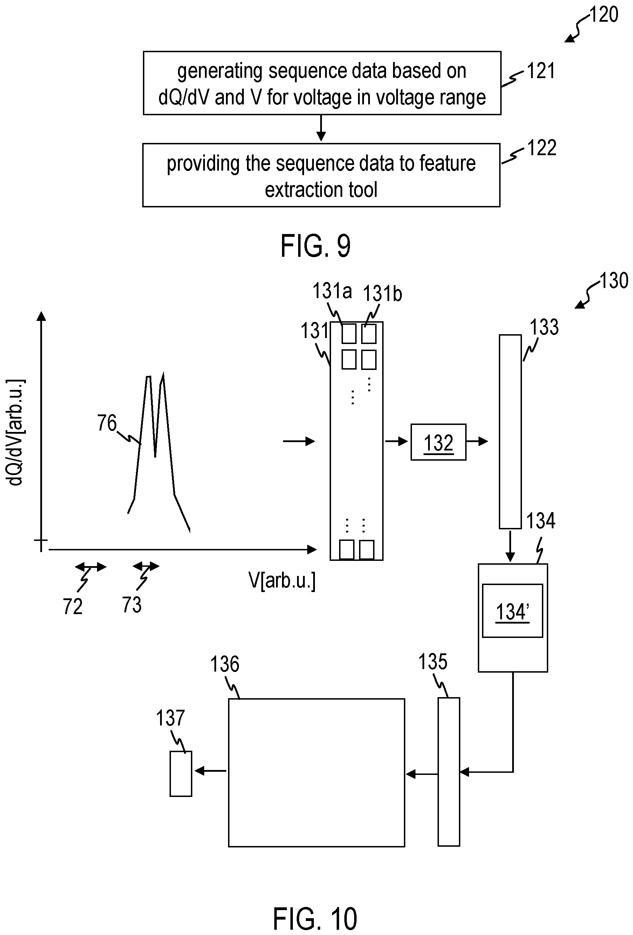

Figure 9 is a flow chart of a process 120. The process 120 may be performed automatically by the data processing system 20. The process 120 is a process of performing the feature extraction. The process 120 may be implemented in process block 63 of Figure 2, in process block 105 of Figure 6, or in process block 114 of Figure 7.

At process block 121, sequence data is generated from the ICA data in a voltage range selected from the set of predefined voltage ranges. The sequence data may be sequence data other than time sequence data. The sequence data may comprise a sequence of values for dQ/dV and associated voltages V.

At process block 122, the sequence data is provided to a feature extraction tool. Various feature extraction tools operative to perform feature extraction on sequence data are available to the skilled person. For illustration rather than limitation, there exist various open source feature extraction tools (such as Python feature extraction tools, e.g., the feature extraction library tsfresh) that can be used. Alternatively or additionally, domain-knowledge based techniques can be used to perform the feature extraction.

Figure 10 is a schematic representation to further illustrate operation of the data processing system 20 and of the methods 60, 100, 110. The ICA data 76 covering at least a voltage range 73 from the set of predefined voltage ranges is subject to processing 130 in the data processing system 20 and of the methods 60, 100, 110. The data processing system 20 may be operative to perform the processing 130.

The processing 130 may comprise a generation of sequence data 131 from the ICA data. The sequence data 131 may comprise a sequence of 2-tuples, each including a voltage value 131a and an associated value of dQ/dV determined as described in detail in association with Figure 1 and Figure 2. The sequence data 131 are supplied to a feature extraction tool 132. The feature extraction tool outputs features 133. A number of features in the output of the feature extraction tool may be less than (e.g., at most 70% or at most 60% or at most 40%) a number of 2-tuples in the sequence data 131. An input generator 134 generates input 135 for the data-driven processing model 136. The input generator 134 may comprise a collinearity analysis 134'. The input generator 134 may generate the input 135 based on a sub-set of the features 133 determined, based on the collinearity analysis 134', to include non-redundant information. The input generator 134 may remove features determined to be redundant (e.g., because they are linear combinations of other features) in the collinearity analysis 134' when generating the input 135. The data-driven processing model 136 may process the input 135. The data-driven processing model 136 is operative to provide, responsive to the input 135, output 137 that comprises the SOH indicator.

The data processing system 20 and the methods 60, 100, 110 are operative to quantitatively assess the SOH, e.g., by determining the ratio of capacity at the time of capturing the current and voltage measurements to the capacity at BOL. The data processing system 20 and the methods 60, 100, 110 are operative to perform this determination of the SOH indicator even when current and voltage measurements are available for a voltage range that is (much) smaller than the voltage interval that corresponds to a 0-100% DOD charging / discharging cycle.

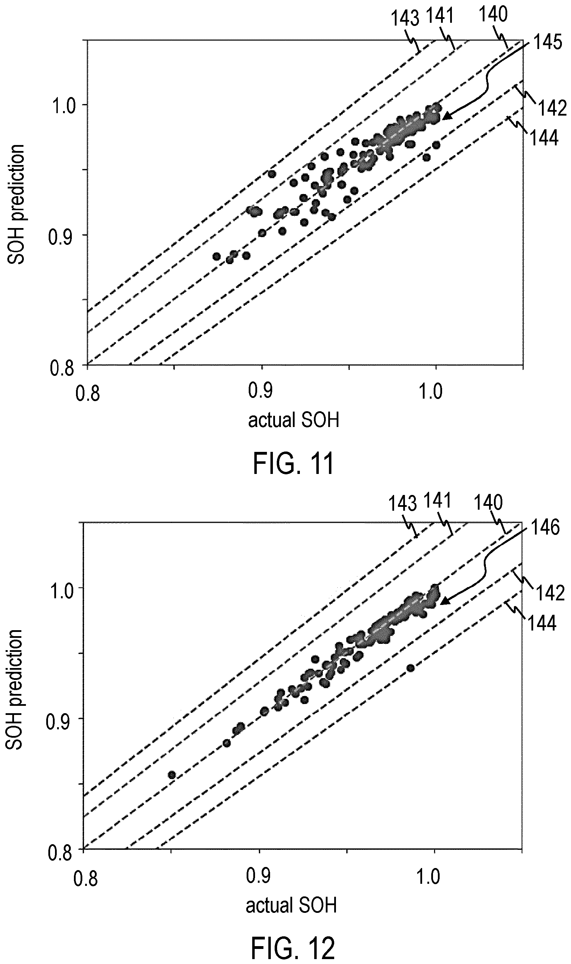

Figure 11 and Figure 12, show data representing how well the SOH indicator (as ratio of capacity vs. BOL capacity) determined by the data processing system 20 and the methods 60, 100, 110 correlates with the actual SOH (also determined as ratio of the capacity vs. BOL capacity). The actual SOH is determined using full 0-100% charging /discharging cycles in an offline mode. Dotted line 140 corresponds to the SOH indicator determined using the data processing system or method disclosed herein being equal to the actual SOH (i.e., perfect prediction). Dotted lines 141, 142 represent a deviation of ± 3 %. Dotted lines 143, 144 represent a deviation of ± 5 %.

Figure 11 and Figure 12 show the results 145, 146 for different voltage ranges. The voltage range for which ICA data were available in Figure 11 has a size of 0.1 V, with the data in Figure 11 being obtained from CC charging mode operation. The voltage range for which ICA data were available in Figure 12 has a size of 0.1 V, with the data in Figure 12 being obtained from CC discharging mode operation. As evidenced, the techniques disclosed herein are operative to predict the SOH, based on ICA data obtained for an interval that is small (e.g., 0.2 V or less or 0.1 V or less) compared to the voltage interval 74 corresponding to a full 0-100 % DOD charging/discharging cycle. The accuracy is better than ± 5 % (Figure 11 and Figure 12) for a voltage range of a size of 0.1 V and better than ± 3 % for a voltage range of a size of 0.2 V in the experiments conducted (not shown). As confirmed by experiments, the obtained accuracy depends on the voltage range size (with greater voltage ranges generally providing even better accuracy) and the location of the voltage range 71, 72, 73 within the voltage interval 74. The accuracy may be dependent on the battery cell type, i.e., it may be affected by the battery chemistry. Thus, it will be appreciated that the results of Figure 11 and Figure 12 are merely illustrative and non-limiting.

The results of Figure 11 and Figure 12 were obtained using a feature extraction tool that extracts more than 200 features (in the specific cases, 273 and 254 features, respectively) and using a data-driven processing model (in the present case a gradient boosting model, such as XGBoost) to process the features. The data-driven processing model was trained using a training set from offline battery aging tests performed on the same battery cell type, with the training set being split into training (70%), test (20%) and validation (10%) data. The battery cells were artificially aged by exposure to heat in the offline aging tests.

The data-driven processing model is advantageously trained using offline battery aging tests.

Figure 13 is a flow chart of a method 160 of providing the data-driven processing model. The method 160 may be performed by or under the control of a computing system different from the data processing system 20 or by or under the control of the data processing system 20 itself. The method 160 may comprise an iteration over several (N, which may be, e.g., at least ten, at least twenty, or at least thirty) aging periods.

At process block 161, a battery aging period is started. The battery aging test is performed with a battery having a same battery cell type as the BESS for which the data-driven processing model is to be used.

At process block 162, a Reference Performance Test (RPT) is performed. The RPT may comprise a 0-100% DOD charging / discharging cycle. Current and voltage measurements may be obtained during the RPT. The RPT may comprise CC mode charging and/or discharging in at least several predefined voltage ranges, which may be determined based on the ICA data (e.g., based on the voltages at which ICA curves exhibit significant changes as a function of SOH) and/or may be predefined (e.g., as several voltage ranges having a size that may be configurable by an operator).

At process block 163, an ICA is performed based on the RPT. At process block 164, the ICA data may be segmented into several segments corresponding to different voltage ranges of the set of predefined voltage ranges.

At process block 165, an SOH determination is performed based on the RPT.

At process block 166, the ICA segment data for each of the several segments of ICA data may be stored in association with the SOH, with the SOH from process block 165 representing a label for supervised training.

Process blocks 161 to 166 are repeated several times, until a termination criterion is fulfilled. The termination criterion may comprise a threshold comparison of a number of repetitions and/or may be based on the SOH determined in the most recent iteration (e.g., termination responsive to the capacity having degraded to 80%).

At process block 167, the data-driven processing model (such as a gradient boosting model) may be trained using the ICA segment data, each representing the ICA data over a voltage range. Training the data-driven processing model may comprise determining parameter values of parameters of the data-driven processing model. Training the data-driven processing model may optionally comprise determining hyperparameters of the data-driven processing model.

The method 160 may comprise deploying the data-driven processing model for use in inference by the data processing system 20 to perform the online SOH diagnosis of a BESS.

Figure 14 is a flow chart of a procedure 170. The procedure 170 may be performed automatically by the computing system that controls or performs the method 160 of Figure 13. The procedure 170 may be performed in process block 167 of the method 160 of Figure 13.

At process block 171, sequence data are generated from the ICA data, for each of the several predefined voltage ranges. At process block 172, a feature extraction is performed. Process blocks 171, 172 may be performed analogously to the explanations provided in association with process blocks 62, 63 of the method 60.

At process block 173, supervised training of the data-driven processing model is performed. The supervised training may comprise adjusting, in an iterative procedure, the parameter values of the data-driven processing model, to cause the data-driven processing model to output the SOH with which the features extracted at process block 172 are labeled (based on the SOH determination at process block 165).

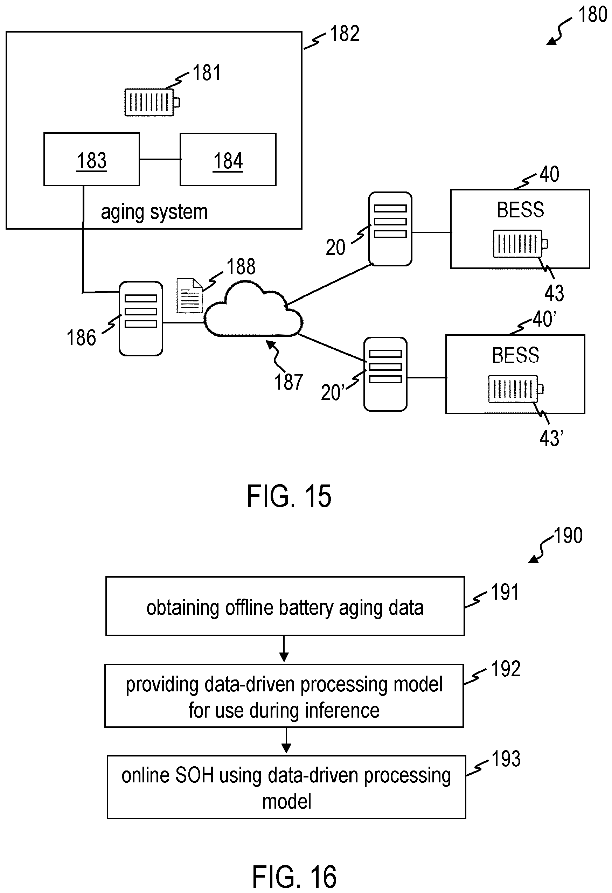

Figure 15 is a schematic representation of a system 180 that may be operative to provide the data-driven processing model to the data processing system 20 for use in performing the online SOH diagnosis of the BESS 40. The system 180 comprises a computing system 186 operative to set the parameters of the data-driven processing model in supervised training. Thereby, the data-driven processing model is provided so as to be operative to output the SOH indicator responsive to an input that comprises features extracted from ICA data over a voltage range selected from a set of predefined voltage ranges. To determine the parameter values, the computing system 186 may be operative to communicatively interface with an aging system 182. The aging system 182 is operative to expose an aging test battery 181 to stress (such as thermal stress, current stress, DOD stress, and/or SOC stress) in a controllable manner. The aging system 182 may comprise a stress source 184 operative to expose the aging test battery to stress in a controllable manner. The stress source 184 may comprise any one or any combination of a thermal stress source; a current stress source; a DOD stress source; a SOC stress source The aging system 182 may comprise a control system 183 operative to control the stress source 184. The computing system 186 may be operative to communicatively interface with the control system 183 to cause degradation of the SOH of the aging test battery 181 over several RPTs as performed in the method 160 of Figure 13. The computing system 186 may perform the method 160 of Figure 13 to provide the data-driven processing model. The computing system 186 may be operative to process current and voltage measurements captured during the RPTs to determine the ICA in process block 163. The computing system 186 may be operative to communicatively interface with measurement instrumentation to obtain the current and voltage measurements captured during the RPTs to determine the ICA.

The computing system 186 may be operative to provide the data-driven processing model to the data processing system 20 that is operative to perform the online SOH diagnosis for a BESS 40 having a battery 43 with an identical battery cell type as the aging test battery 181. Providing the data-driven processing model may comprise providing data 188 defining the parameter values determined by the computing system 186. The computing system 186 may be operative to provide the parameter values 188 via a communication system 187 which may comprise a wide area network (WAN) and/or a cellular communication system. The data processing system 20 may be operative to obtain the parameter values, e.g., by communicatively interfacing with the computing system 186. The data processing system 20 may be operative to persistently store the parameter values, which define the data-driven processing model, and use the parameter values to apply the data-driven processing model 34.

The data-driven processing model may be provided to more than one processing system 20. For illustration, a further processing system 20' or several further processing systems 20' may be operative to receive the parameter values 188 that define the data-driven processing model configuration, and may use the same during inference for an online SOH diagnosis of a further BESS 40' having a further battery 43' with a same battery cell type as the aging test battery 181.

Both during training and during inference, redundant information may be removed from the extracted features to generate the input for the data-driven processing model.

Figure 16 is a flow chart of a method 190. The method 190 may be performed automatically by the computing system 186 in association with the processing system 20 and, if present, the one or several further processing system 20'. The method 190 may be performed automatically by the system 180.

At process block 191, offline battery aging data are obtained. The offline battery aging data comprise ICA data obtained for the several voltage ranges and/or features extracted from the ICA data over the several voltage ranges. The offline battery aging data comprise an SOH that may be determined by 0-100% DOD charging / discharging cycle, which is useful as label for ML model training. Process block 191 may comprise the method 160 of Figure 13.

At process block 192, a data-driven processing model obtained based on the offline battery aging data (e.g., based on ML performed using the offline battery aging data) is provided to one or several data processing system(s) 20, 20' for use during inference. Providing the data-driven processing model may comprise any one or any combination of the following, without being limited thereto: transmitting model parameters of the data-driven processing model determined based on the offline battery aging data; transmitting executable instruction code that, upon execution by at least one programmable circuit, causes the data-driven processing model to be applied to features extracted from the ICA data over a voltage range 71, 72, 73 during inference; storing executable instruction code in a memory or storage system of the data processing system(s) 20, 20', the executable instruction code being operative to, upon execution by at least one programmable circuit, cause the data-driven processing model to be applied to features extracted from the ICA data over a voltage range 71, 72, 73 during inference.

At process block 193, a data processing system 20, 20' performs an online SOH diagnosis of a BESS, by applying the data-driven processing model to features extracted from the ICA data over a voltage range 71, 72, 73.

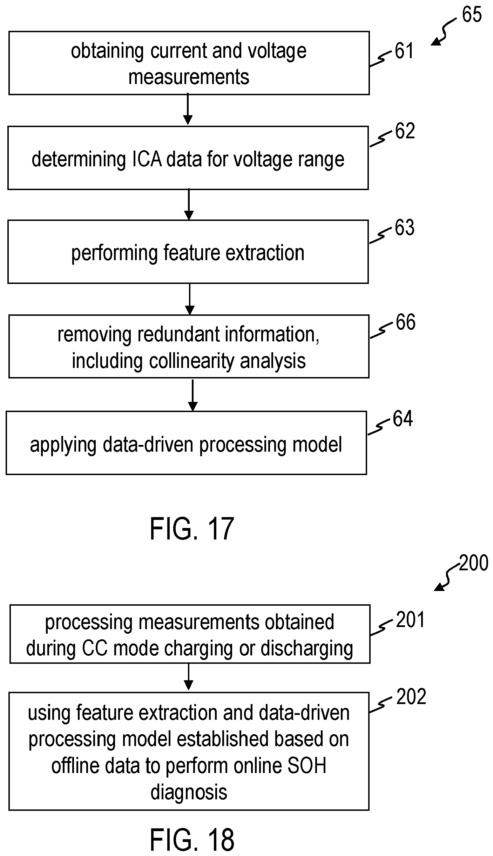

Figure 17 is a flow chart of a method 65. The method 65 may be performed automatically by the data processing system 20 during inference, i.e., when using the data-driven processing model to perform the online SOH diagnosis. Process blocks 61, 62, 63, and 65 may be implemented as discussed in detail in association with Figure 2. The method 65 further comprises a process block 66 of generating input to the data-driven processing model, which comprises removing redundant information from the features extracted at process block 63. Identifying redundant information may comprise a collinearity analysis. The input may be those of the features determined, based on the collinearity analysis, to represent non-redundant information. The input may also comprise linear combinations of such features, in which linear combinations redundancy has been reduced or removed.

When determining the data-driven processing model, different sets of parameter values may be determined, each being associated with one of the predefined voltage ranges of the set of predefined voltage ranges. The data processing system 20 may be operative to apply the data-driven processing model with the parameters for the respective voltage range (i.e., the voltage range for which the ICA data were obtained) to determine the SOH indicator during inference.

In the techniques disclosed herein, the results of offline battery aging tests may be used to determine how ICA data over a voltage range selected from a set of predefined voltage ranges are to be processed to determine the SOH indicator.

Figure 18 is a flow chart of a method 200 to further illustrate this concept. At process block 201, battery aging test measurements are processed that were obtained during CC mode charging or CC mode discharging during offline battery aging tests. Processing the battery aging test measurements may comprise determining the battery aging test ICA data for each one of several predefined voltage ranges, and determining parameter values of a data-driven processing model based on this segmented battery aging test ICA data and a SOH determined for a respective RPT cycle. The parameter values of the data-driven processing model may be determined based on battery aging test features extracted from the battery aging test ICA data. Processing the measurements may comprise determining parameter values for a data-driven processing model (such as a gradient boosting model), based on the ICA data and the SOH. The parameter values may be determined for each of several voltage ranges, for subsequent use by the data processing system 20.

At process block 202, during inference, feature extraction is applied to ICA data obtained from measurements captured during online BESS operation during CC mode charging or CC mode discharging of the BESS. The data-driven processing model that has been established based on the offline battery aging tests may be used to perform the online SOH diagnosis of the BESS.

Referring to Figure 15, Figure 16, Figure 17, and Figure 18, during the offline battery aging test, a series of reference performance test (RPT) is run between different aging intervals (e.g., between stresses induced aging periods). Within each individual RPT test, a full charging, full discharging test can be performed to obtain the SOH, which may be determined as the remaining cell capacity divided by BOL capacity. During online field application, there are generally rare opportunities to conduct a full charging or discharging cycle. Thus, the data processing system 20 and the methods disclosed herein provide a way to utilize the offline battery cell aging data during online SOH diagnosis.

The aging test data can be employed in various ways, such as:

- The set of predefined voltage ranges 71, 72, 73 can be defined according to the ICA curves obtained during battery aging tests. The set of predefined voltage ranges 71, 72, 73 can be defined such that the voltage ranges 71, 72, 73 can cover at least one of the major peaks in order to capture as much battery aging information as possible.
- The charging/discharging aging test data can be split into several aging test ICA data segments according to set of predefined voltage ranges 71, 72, 73. This allows a series of aging test IC curve segments to be determined separately. The series of aging test IC curve segments can be labelled with the SOH information, which resulted from their RPT data.
- Aging test features are extracted from the aging test IC data segments. This may comprise the use of a feature extraction tool and/or domain knowledge.
- Redundancy of extracted aging test features can be identified and removed by collinearity analysis
- Supervised ML model training can be performed using the aging test features from the aging test ICA data segments (with redundant information removed therefrom) and SOH labels.
- During field operation, the BMS 42 can actively control the current to perform charging or discharging in CC mode if the battery voltage enters one of the predefined voltage ranges.
- The data-driven processing model may be used to perform the online SOH diagnosis during inference.

Various effects and advantages are attained by the data processing system and the method of performing an online BESS diagnosis. The method and data processing system allows the SOH diagnosis to be performed without requiring the BESS to be disassembled from its installation site and/or can determine the SOH without requiring a full charging cycle and/or a full discharging cycle to be performed. The method and data processing system allows the online SOH diagnosis to be performed using measurements collected during a part of a charging or discharging cycle, while offering the versatility of performing the online SOH diagnosis based on any one of several distinct parts of a load profile in which constant current mode charging or constant current mode discharging is performed.

The techniques disclose herein allow the online SOH diagnosis to be performed based on a voltage range selected from a set of predefined voltage ranges, taking advantage of a data-driven processing model that can be established based on offline battery aging tests. This provides a technical effect over techniques such as those of CN 116 299 003 A, CN 116 125 289 A, and CN 113 721 159 A. For illustration, the techniques disclosed herein can be more readily integrated into the field operation of a BESS.

While embodiments have been described in detail with reference to the drawings, various modifications may be implemented in other embodiments. For illustration rather than limitation:

- While embodiments have been described in which the data-driven processing model comprises a gradient boosting model, other AI models, in particular other ML models, may be used. For illustration, the techniques disclosed herein may use a data-driven processing model that comprises a neural network, such as a convolutional neural network, a recurrent neural network, a transformer model, an autoencoder model, without being limited thereto. For illustration, the data-driven processing model may comprise any one or any combination of: a linear model; a k-means model; a support vector machine model; a Bayes model; a decision tree model; a gradient boosting model; a deep neural network, without being limited thereto.
- While embodiments have been described in which the predefined voltage ranges may have a size that may be, for example, 0.5 V or less, 0.4 V or less, 0.3 V or less, 0.2 V or less, or 0.1 V or less, the techniques disclosed herein are not limited thereto. The size may be dependent on the battery cell type of the BESS for which the techniques are to be applied.
- The number of voltage ranges included in the set of predefined voltage ranges may be at least two, at least three, at least four, or at least five. The number of voltage ranges included in the set of predefined voltage ranges may be dependent on the battery cell type of the BESS for which the techniques are to be applied.
- While supervised training may be used to determine parameter values for the data-driven processing model, the techniques may alternatively or additionally also use semi-supervised or unsupervised training techniques.

Embodiments may be used in association with a power grid having renewables penetration, such as power grid comprising renewable energy systems (such as DERs), and/or HVDC systems, without being limited thereto.

This description and the accompanying drawings that illustrate aspects and embodiments of the present invention should not be taken as limiting-the claims defining the protected invention. In other words, while the invention has been illustrated and described in detail in the drawings and foregoing description, such illustration and description are to be considered illustrative and not restrictive. Various mechanical, compositional, structural, electrical, and operational changes may be made without departing from the spirit and scope of this description and the claims. In some instances, well-known circuits, structures, and techniques have not been shown in detail in order not to obscure the invention. Thus, it will be understood that changes and modifications may be made by those of ordinary skill within the scope and spirit of the following claims. In particular, the present invention covers further embodiments with any combination of features from different embodiments described above and below.

The disclosure also covers all further features shown in the Figures individually although they may not have been described in the afore or following description. Also, single alternatives of the embodiments described in the Figures and the description and single alternatives of features thereof can be disclaimed from the subject matter of the invention or from disclosed subject matter. The disclosure comprises subject matter consisting of the features defined in the claims or the embodiments as well as subject matter comprising said features.

The term "comprising" does not exclude other elements or process blocks, and the indefinite article "a" or "an" does not exclude a plurality. A single unit or process block may fulfil the functions of several features recited in the claims. The mere fact that certain measures are recited in mutually different dependent claims does not indicate that a combination of these measures cannot be used to advantage. Components described as coupled or connected may be electrically or mechanically directly coupled, or they may be indirectly coupled via one or more intermediate components. Any reference signs in the claims should not be construed as limiting the scope.

A machine-readable instruction code may be stored/distributed on a suitable medium, such as an optical storage medium or a solid-state medium supplied together with or as part of other hardware, but may also be distributed in other forms, such as via a wide area network or other wired or wireless telecommunication systems. Furthermore, a machine-readable instruction code can also be a data structure product or a signal for embodying a specific method such as the method according to embodiments.

**Claims**

1. A method of performing an online state of health, SOH, diagnosis for a battery energy storage system, BESS (40), the method comprising:

   obtaining, by a data processing system (20; 20, 20'), current measurements and voltage measurements as functions of time over a time interval, the current measurements and the voltage measurements being captured during charging or discharging of the BESS (40) in constant current mode throughout the time interval, the current measurements and the voltage measurements being obtained for a voltage range (71, 72, 73) selected from a set of predefined voltage ranges (71-73);
   determining, by the data processing system (20; 20, 20'), incremental capacity analysis, ICA, data (75, 76) for the voltage range (71, 72, 73) based on the current measurements and the voltage measurements, wherein determining the ICA data (75, 76) comprises determining, for each of a plurality of voltage values in the voltage range, an incremental change in charge stored by the BESS (40) that is associated with an incremental change in voltage;
   performing, by the data processing system (20; 20, 20'), a feature extraction (33; 132) to extract features (133) from the ICA data (75, 76) for the voltage range; and
   applying, by the data processing system (20; 20, 20'), a data-driven processing model (34; 136), wherein the data-driven processing model (34; 136) receives an input (135) that is based on the features (133), and wherein the data-driven processing model (34; 136) outputs an SOH indicator (137).

2. The method of claim 1, wherein the online SOH diagnosis is performed with the BESS (40) remaining in situ at an installation site of the BESS (40) and without disassembly of the BESS (40).

3. The method of any one of the preceding claims, further comprising applying a collinearity analysis to the features (133) to generate the input (135) of the data-driven processing model (34; 136).

4. The method of any one of the preceding claims, wherein the data-driven processing model (34; 136) comprises model parameters (29) that are set based on aging test measurements obtained in time periods in which an aging test battery (181) charging and/or an aging test battery discharging is performed in the constant current mode during offline battery aging tests.

5. The method of claim 4, further comprising generating, by the data processing system (20; 20, 20') or by a computing system (183) separate from the data processing system (20; 20, 20'), the data-driven processing model (34; 136), comprising:

   obtaining aging test ICA data (78, 79) based on aging test current measurements and aging test voltage measurements captured as functions of time during the offline battery aging tests;
   segmenting the aging test ICA data (78, 79) into several segments associated with the predefined voltage ranges (71-73) of the set of predefined voltage ranges (71-73);
   extracting aging test features from the several segments of the aging test ICA data (78, 79); and
   setting the model parameters (29) of the data-driven processing model (34; 136) based on the aging test features (133) and based on labels indicative of the SOH of the aging test battery (181) or the SOHs of several aging test batteries (181) for which the aging test ICA data (78, 79) are obtained.

**6.** The method of claim 5, wherein setting the model parameters (29) comprises setting the model parameters (29) using supervised training and based at least on the aging test ICA data (78, 79) obtained from the aging test measurements captured while the aging test charging and/or the aging test discharging is performed in the constant current mode during the offline battery aging tests.

**7.** The method of any one of the preceding claims, further comprising actively controlling, by an active battery management system, BMS (42a), the charging or the discharging of the BESS (40) in the constant current mode to obtain the current measurements and the voltage measurements for the voltage range (71, 72, 73) selected from the set of predefined voltage ranges (71-73).

**8.** The method of any one of claims 1 to 6, wherein the BESS (40) is controlled by a passive battery management system, BMS (42), and wherein the online SOH diagnosis is performed conditionally dependent on the BESS (40) being charged or discharged in the constant current mode with voltages in the voltage range (71, 72, 73) selected from the set of predefined voltage ranges (71-73).

**9.** The method of any one of the preceding claims, further comprising performing, by the data processing system (20; 20, 20'), a control operation based on the SOH indicator (137).

**10.** The method of claim 9, wherein the control operation comprises one or both of:

controlling a human machine interface (27) based on the SOH indicator (137);
controlling a data interface (21) to trigger a control operation affecting the BESS (40).

**11.** A method of providing a data-driven processing model (34; 136) for online state of health, SOH, diagnosis for a battery energy storage system, BESS (40), the method comprising:

obtaining, by at least one processing circuit (183), aging test incremental capacity analysis, ICA, data (78, 79) based on aging test current measurements and aging test voltage measurements captured as functions of time during offline battery aging tests;
segmenting, by the at least one processing circuit (183), the aging test ICA data (75, 76) into several segments associated with predefined voltage ranges (71-73) of a set of predefined voltage ranges (71-73);
extracting, by the at least one processing circuit, aging test features (133) from the several segments;
setting, by the at least one processing circuit, model parameters (29) of the data-driven processing model (34; 136) based on the aging test features (133) and based on labels indicative of the SOH of the aging test battery (181) or the SOHs of several aging test batteries (181) for which the aging test ICA data (78, 79) are obtained, wherein the model parameters (29) are set to configure the data-driven processing model (34; 136) such that it is operative to receive an input (135) that is based on features (133) extracted from ICA data (75, 76) obtained for the BESS (40) for which the online SOH diagnosis is performed and to output an SOH indicator (137) for the BESS (40); and
providing, by the at least one processing circuit, the data-driven processing model (34; 136) for performing the online SOH diagnosis.

**12.** Machine-readable instruction code comprising instructions which, when executed by at least one programmable circuit (30; 183), cause execution of the method of any one of the preceding claims.

**13.** A data processing system (20; 20, 20') for performing an online state of health, SOH, diagnosis for a battery energy storage system, BESS (40), the data processing system (20; 20, 20') comprising:

an interface (21) operative to obtain current measurements and voltage measurements as functions of time over a time interval, the current measurements and the voltage measurements being captured during charging or discharging of the BESS (40) in constant current mode, the current measurements and the voltage measurements being obtained for a voltage range (71, 72, 73) selected from a set of predefined voltage ranges (71-73); and
at least one processing circuit (30) operative to:

determine incremental capacity analysis, ICA, data (75, 76) for the voltage range (71, 72, 73) based on the current measurements and the voltage measurements, the at least one processing circuit being operative to determine, for each of a plurality of voltage values in the voltage range, an incremental change in charge stored by the BESS (40) that is associated with an incremental change in voltage;

perform a feature extraction (33; 132) to extract features (133) from the ICA data (75, 76) for the voltage range; and

apply a data-driven processing model (34; 136), wherein the data-driven processing model (34; 136) is operative to receive an input (135) that is based on the features (133), and wherein the data-driven processing model (34; 136) is operative to output an SOH indicator (137).

14. The data processing system (20; 20, 20') of claim 13, wherein the data processing system (20; 20, 20') is operative to perform the method of any one of claims 1 to 11.

15. A system, comprising:

a battery energy storage system, BESS (40),

measurement instrumentation (45, 46; 47), and

the data processing system (20; 20, 20') of claim 13 or claim 14 operative to communicatively interface with the measurements instrumentation (45, 46; 47) to obtain the current measurements and the voltage measurements to perform the online SOH diagnosis.

FIG. 1

obtaining current and voltage measurements ⌐61

determining ICA data for voltage range ⌐62

performing feature extraction ⌐63

applying data-driven processing model ⌐64

60

FIG. 2

dQ/dV[arb.u.]

76

75

V[arb.u.]

71    72    73

FIG. 3

FIG. 4

FIG. 5

FIG. 6

FIG. 7

FIG. 8

120

| generating sequence data based on dQ/dV and V for voltage in voltage range | 121 |

↓

| providing the sequence data to feature extraction tool | 122 |

## FIG. 9

130

dQ/dV[arb.u.]

76

131a  131b

131

132

133

134

134'

V[arb.u.]

72    73

136

137    135

## FIG. 10

FIG. 11

FIG. 12

160

starting battery ageing period — 161

RPT — 162

ICA — 163

N repetitions

segmentation by voltage range — 164

SOH determination — 165

storing ICA segment data in association with SOH — 166

training data-driven processing model — 167

FIG. 13

170

generating training sequence data based on dQ/dV and V for each of several voltage ranges — 171

feature extraction — 172

supervised training with training sequence data labeled with SOH — 173

FIG. 14

FIG. 15

obtaining offline battery aging data — 191

↓

providing data-driven processing model
for use during inference — 192

↓

online SOH using data-driven processing
model — 193

FIG. 16

```
                                                              ⌐65
┌─────────────────────────────────┐ ⌐61    ↙
│   obtaining current and voltage  │
│          measurements            │
└─────────────────────────────────┘
                 │
                 ▼
┌─────────────────────────────────┐ ⌐62
│  determining ICA data for voltage range │
└─────────────────────────────────┘
                 │
                 ▼
┌─────────────────────────────────┐ ⌐63
│    performing feature extraction │
└─────────────────────────────────┘
                 │
                 ▼
┌─────────────────────────────────┐ ⌐66
│   removing redundant information,│
│    including collinearity analysis │
└─────────────────────────────────┘
                 │
                 ▼
┌─────────────────────────────────┐ ⌐64
│  applying data-driven processing model │
└─────────────────────────────────┘
```

FIG. 17

```
                                                              ⌐200
                                                      ↙
┌─────────────────────────────────┐ ⌐201
│  processing measurements obtained │
│  during CC mode charging or discharging │
└─────────────────────────────────┘
                 │
                 ▼
┌─────────────────────────────────┐ ⌐202
│  using feature extraction and data-driven │
│  processing model established based on │
│  offline data to perform online SOH │
│            diagnosis             │
└─────────────────────────────────┘
```

FIG. 18

**EUROPEAN SEARCH REPORT**

Europäisches
Patentamt
European
Patent Office
Office européen
des brevets

**Application Number**

EP 24 16 7973

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WANG YUJIE ET AL: "Health Diagnosis for Lithium-Ion Battery by Combining Partial Incremental Capacity and Deep Belief Network During Insufficient Discharge Profile", IEEE TRANSACTIONS ON INDUSTRIAL ELECTRONICS, IEEE SERVICE CENTER, PISCATAWAY, NJ, USA, vol. 70, no. 11, 30 November 2022 (2022-11-30), pages 11242-11250, XP011940235, ISSN: 0278-0046, DOI: 10.1109/TIE.2022.3224201 [retrieved on 2022-12-01] | 1-6,9-15 | INV. G01R31/392 |
| Y | * the whole document * | 3-10,15 | |
| X | US 2022/229121 A1 (FAN GUODONG [US]) 21 July 2022 (2022-07-21) | 1,2, 11-14 | |
| Y | * the whole document * | 3-10,15 | |
| Y | LI YI ET AL: "Data-driven health estimation and lifetime prediction of lithium-ion batteries: A review", RENEWABLE AND SUSTAINABLE ENERGY REVIEWS, vol. 113, 12 July 2019 (2019-07-12), page 109254, XP093015954, US ISSN: 1364-0321, DOI: 10.1016/j.rser.2019.109254 | 7,8 | **TECHNICAL FIELDS SEARCHED (IPC)** G01R |
| A | * the whole document * | 1-6,9-15 | |
| A | US 2021/311129 A1 (YEZERETS ALEKSEY [US] ET AL) 7 October 2021 (2021-10-07) * the whole document * | 1-15 | |
| A | US 2024/027537 A1 (LIM BO MI [KR] ET AL) 25 January 2024 (2024-01-25) * the whole document * | 1-15 | |

-/--

The present search report has been drawn up for all claims

| Place of search | Date of completion of the search | Examiner |
|---|---|---|
| Munich | 25 September 2024 | Ako, Thomas |

EPO FORM 1503 03.82 (P04C01)

Europäisches
Patentamt

European
Patent Office

Office européen
des brevets

**EUROPEAN SEARCH REPORT**

Application Number

EP 24 16 7973

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | KIM JAEYEONG ET AL: "A Study of incremental capacity analysis discrete wavelet transform-based feature extraction with stochastic analysis", 2023 25TH EUROPEAN CONFERENCE ON POWER ELECTRONICS AND APPLICATIONS (EPE'23 ECCE EUROPE), EPE ASSOCIATION, 4 September 2023 (2023-09-04), pages 1-7, XP034437638, DOI: 10.23919/EPE23ECCEEUROPE58414.2023.10264574 [retrieved on 2023-10-03] * the whole document * | 1-15 | |

-----

| | | | TECHNICAL FIELDS SEARCHED (IPC) |
|---|---|---|---|

The present search report has been drawn up for all claims

| Place of search | Date of completion of the search | Examiner |
|---|---|---|
| Munich | 25 September 2024 | Ako, Thomas |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

........................................................................

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 24 16 7973

This annex lists the patent family members relating to the patent documents cited in the above-mentioned European search report.
The members are as contained in the European Patent Office EDP file on
The European Patent Office is in no way liable for these particulars which are merely given for the purpose of information.

25-09-2024

| Patent document cited in search report | | Publication date | Patent family member(s) | | Publication date |
|---|---|---|---|---|---|
| US 2022229121 | A1 | 21-07-2022 | CN | 113924502 A | 11-01-2022 |
| | | | EP | 3983814 A1 | 20-04-2022 |
| | | | US | 2022229121 A1 | 21-07-2022 |
| | | | WO | 2020251854 A1 | 17-12-2020 |
| US 2021311129 | A1 | 07-10-2021 | CN | 113495222 A | 12-10-2021 |
| | | | US | 2021311129 A1 | 07-10-2021 |
| US 2024027537 | A1 | 25-01-2024 | CN | 116724243 A | 08-09-2023 |
| | | | EP | 4235198 A1 | 30-08-2023 |
| | | | JP | 2024500788 A | 10-01-2024 |
| | | | KR | 20220100470 A | 15-07-2022 |
| | | | US | 2024027537 A1 | 25-01-2024 |
| | | | WO | 2022149824 A1 | 14-07-2022 |

EPO FORM P0459

For more details about this annex : see Official Journal of the European Patent Office, No. 12/82

**REFERENCES CITED IN THE DESCRIPTION**

**Patent documents cited in the description**

- CN 116299003 A
- CN 116125289 A

- CN 113721159 A